# EUROPEAN PATENT APPLICATION

(11) **EP 4 797 899 A1**
(43) Date of publication of application: **26.08.2026**
(21) Application number: 23955824.0
(22) Date of filing: 20.10.2023
(51) Int. Cl.: H10B 53/30

(54) **STORAGE UNIT, STORAGE ARRAY, MEMORY, AND ELECTRONIC DEVICE**

(71) Applicant: HUAWEI TECHNOLOGIES CO., LTD., Shenzhen 518129 (CN)
(72) Inventor: YU, Fangzhou, Shenzhen, Guangdong 518129 (CN); HUAN, Yahuan, Shenzhen, Guangdong 518129 (CN); FENG, Zexin, Shenzhen, Guangdong 518129 (CN); LIANG, Zhongxin, Shenzhen, Guangdong 518129 (CN); WU, Jialu, Shenzhen, Guangdong 518129 (CN); ZHANG, Heng, Shenzhen, Guangdong 518129 (CN); XU, Jeffrey Junhao, Shenzhen, Guangdong 518129 (CN)
(74) Representative: Epping - Hermann - Fischer
(86) International application number: PCT/CN2023/125793
(87) International publication number: WO 2025/081503

(57) **Abstract**

Embodiments of this application, relating to the field of semiconductor storage technologies, provide a memory cell, a memory array, a memory, and an electronic device, to alleviate a problem of high power consumption of a ferroelectric memory. A memory capacitor of the memory cell includes a first electrode, a ferroelectric layer, a first metal oxide layer, and a second electrode. The first metal oxide layer is stacked between the first electrode and the ferroelectric layer. A metal element of a first metal oxide in the first metal oxide layer includes at least one metal element from group III, group IV, or group V element, excluding hafnium. The first metal oxide layer applies a proper tensile force to the ferroelectric layer, to stretch a crystal structure of the ferroelectric layer, so that the crystal structure of the ferroelectric layer has a lattice distortion, to increase a proportion of an O phase in the ferroelectric layer, thereby increasing ferroelectricity of the ferroelectric layer. This makes it easier for the memory to implement a ferroelectric polarity reversal, and reduces an operating voltage and power consumption.

## Description

### TECHNICAL FIELD

This application relates to the field of semiconductor storage technologies, and in particular, to a memory cell, a memory array, a memory, and an electronic device.

### BACKGROUND

Compared with volatile memories, non-volatile memories can still store data even when a power supply is removed, and therefore the demand for non-volatile memories in electronic devices is increasing. As a type of non-volatile memory, ferroelectric memories include a ferroelectric material having an electric dipole. Different polarities of the electric dipole may be switched by adjusting voltage applied to the ferroelectric material, to implement switching between different polarization states, thereby implementing storage of binary numbers "1" and "0". However, power consumption of current ferroelectric memories is high, affecting an application scope of the ferroelectric memories.

### SUMMARY

This application provides a memory cell, a memory array, a memory, and an electronic device, to alleviate a problem of high power consumption of a ferroelectric memory.

To achieve the foregoing objective, this application uses the following technical solutions.

According to one aspect of this application, a memory cell is provided. The memory cell includes a transistor and a memory capacitor electrically connected to the transistor. The memory capacitor may include a first electrode, a ferroelectric layer, a first metal oxide layer, and a second electrode. The ferroelectric layer is stacked with the first electrode, where the ferroelectric layer is a doped hafnium oxide-based ferroelectric layer. The first metal oxide layer is stacked between the first electrode and the ferroelectric layer. The first metal oxide layer may be configured to stretch a crystal structure of the ferroelectric layer, so that the crystal structure of the ferroelectric layer has a lattice distortion. The first metal oxide layer includes a first metal oxide, and a metal element in the first metal oxide may include at least one metal element from group III, group IV, or group V element, excluding hafnium. In addition, the second electrode is stacked on a side that is of the ferroelectric layer and that is away from the first electrode.

In conclusion, the first electrode, the ferroelectric layer, the first metal oxide layer, and the second electrode can form the memory capacitor. When there is a voltage difference between the first electrode and the second electrode, a polarization direction (upward polarization or downward polarization) of a ferroelectric material in the ferroelectric layer may be changed, to implement a read operation of data stored in the memory capacitor. In addition, because the first metal oxide may include the at least one metal element from group III, group IV, or group V element, excluding hafnium, a lattice structure of the first metal oxide layer after crystallization is similar to a lattice structure of the ferroelectric layer after crystallization, so that a chemical bond is easily formed near an interface between the first metal oxide layer and the ferroelectric layer. In addition, in a process of converting the first metal oxide layer and the ferroelectric layer from an amorphous structure to the crystal structure, the first metal oxide layer may stretch the crystal structure of the ferroelectric layer, so that a proper stress is generated near the interface between the first metal oxide layer and the ferroelectric layer. The stress may cause a mismatch between the lattice of the ferroelectric layer and the lattice of the first metal oxide layer, to form a dislocation, so that the lattice structure of the ferroelectric layer has a lattice distortion. The lattice distortion makes the lattice structure of the ferroelectric layer more asymmetric, and increases a proportion of an O phase in the ferroelectric layer. Because the O phase is a main reason for generating ferroelectricity of the doped hafnium oxide-based ferroelectric material, the ferroelectricity of the ferroelectric layer can be increased. Enhancement of the ferroelectricity of the ferroelectric layer can make it easier to implement a polarity reversal of the ferroelectric layer, thereby reducing a coercive field E_{C} of the memory cell. Because the coercive field E_{C} is in direct proportion to an operating electric field and an operating voltage, the operating electric field and the operating voltage of the memory cell can be further reduced, thereby reducing power consumption of the memory cell and the memory having the memory cell.

In an optional implementation, a dielectric constant of the first metal oxide layer is greater than a dielectric constant of the ferroelectric layer, and the dielectric constant of the first metal oxide layer is less than a dielectric constant of the first electrode. In this way, the first metal oxide layer has a strong charge storage capability. When the operating voltage is applied to two sides of the ferroelectric layer, voltage division of the first metal oxide layer on the operating voltage can be reduced, so that a voltage actually applied to the ferroelectric layer is equivalent to the operating voltage, thereby improving utilization of the operating voltage and reducing power consumption.

In an optional implementation, the memory capacitor further includes a second metal oxide layer, and the second metal oxide layer is stacked between the second electrode and the ferroelectric layer. The second metal oxide layer may be configured to stretch a crystal structure of the ferroelectric layer, so that the crystal structure of the ferroelectric layer has a lattice distortion. The second metal oxide layer includes a second metal oxide, and a metal element in the second metal oxide may include at least one metal element from group III, group IV, or group V element, excluding hafnium. Technical effect of the second metal oxide layer is similar to that of the first metal oxide layer. Details are not described herein again.

In an optional implementation, a dielectric constant of the second metal oxide layer is greater than the dielectric constant of the ferroelectric layer, and the dielectric constant of the second metal oxide layer is less than a dielectric constant of the second electrode. Similarly, the second metal oxide layer has a strong charge storage capability. When an operating voltage is applied to two sides of the ferroelectric layer, voltage division of the second metal oxide layer on the operating voltage can be reduced, so that a voltage actually applied to the ferroelectric layer is equivalent to the operating voltage, thereby improving utilization of the operating voltage and reducing power consumption.

In an optional implementation, the memory capacitor includes a plurality of first metal oxide layers: a first bottom metal oxide layer and a first top metal oxide layer. The first top metal oxide layer is stacked on a side that is of the first bottom metal oxide layer and that is away from the first electrode. A material of the first top metal oxide layer is different from a material of the first bottom metal oxide layer. Technical effect of the first bottom metal oxide layer and the first top metal oxide layer is same as that of the first metal oxide layer. Details are not described herein again. In an optional implementation, the memory capacitor includes a plurality of second metal oxide layers: a second bottom metal oxide layer and a second top metal oxide layer. The second top metal oxide layer is stacked on a side that is of the second bottom metal oxide layer and that is away from the second electrode. A material of the second top metal oxide layer is different from a material of the second bottom metal oxide layer. Technical effect of the second bottom metal oxide layer and the second top metal oxide layer is same as that of the second metal oxide layer. Details are not described herein again.

In an optional implementation, the memory capacitor further includes a first transition layer, and the first transition layer is stacked between the first electrode and the first metal oxide layer. The first transition layer includes a third metal oxide, and a metal element in the third metal oxide is the same as at least one metal element of the first electrode. In this way, because the third metal oxide has an oxygen element, an interface between the first metal oxide layer and the first transition layer can be optimized, to reduce defects of the interface. In addition, because the metal element in the third metal oxide may be the same as the at least one metal element of the first electrode, the first transition layer can optimize an interface between the first electrode and the first transition layer, to reduce defects of the interface, so that transition can be performed between the first electrode and the first metal oxide layer, thereby improving performance and reliability of the device.

In an optional implementation, the first electrode includes tungsten, the third metal oxide includes tungsten oxide, and the first electrode and the third metal oxide have a same metal element tungsten. Alternatively, the first electrode includes titanium, the third metal oxide includes titanium oxide, and the first electrode and the third metal oxide have a same metal element titanium. Alternatively, the first electrode includes ruthenium, the third metal oxide includes ruthenium oxide, and the first electrode and the third metal oxide have a same metal element ruthenium.

In an optional implementation, the memory capacitor further includes a second transition layer. The second transition layer is stacked between the second electrode and the second metal oxide layer, where the second transition layer includes a fourth metal oxide, and a metal element in the fourth metal oxide is the same as at least one metal element of the second electrode. Technical effect of the second transition layer is similar to that of the first transition layer. Details are not described herein again.

In an optional implementation, the first metal oxide includes at least one of yttrium oxide, scandium oxide, lanthanum oxide, cerium oxide, titanium oxide, niobium oxide, tantalum oxide, or vanadium oxide. In this way, the first metal oxide can be selected from non-radioactive elements in the group III, group IV, and group V elements, thereby facilitating material acquisition.

In an optional implementation, the first metal oxide includes at least one of lanthanum oxide, cerium oxide, titanium oxide, niobium oxide, tantalum oxide, or vanadium oxide. A dielectric constant of the material is greater than the dielectric constant of the ferroelectric layer, and is less than the dielectric constant of the second electrode.

In an optional implementation, the ferroelectric layer includes hafnium oxide and a doping material, and the doping material includes at least one of zirconium, titanium, niobium, lanthanum, cerium, gadolinium, yttrium, aluminum, or strontium. The elements may be doped to change symmetry of the crystal structure of the hafnium oxide-based ferroelectric material, or an appropriate amount of oxygen vacancies may be introduced to reduce an energy barrier of phase transition, thereby enhancing the ferroelectricity of the hafnium oxide-based ferroelectric material.

In an optional implementation, a thickness of the first metal oxide layer is from 0.5 nm to 2 nm. The thickness of the first metal oxide layer being within a range of 0.5 nm to 2 nm can avoid the metal oxide layer from being too thin, thereby avoiding insufficient stretching action on the ferroelectric layer and an unobvious lattice distortion in the ferroelectric layer. In addition, this can avoid the metal oxide layer from being too thick, thereby avoiding large voltage division on the ferroelectric layer, and avoiding adverse effect on reducing of the operating voltage and ultra-thin design of the product.

In an optional implementation, a thickness of the second metal oxide layer is from 0.5 nm to 2 nm. The thickness of the second metal oxide layer has the same technical effect as the thickness of the first metal oxide layer. Details are not described herein again.

In an optional implementation, a thickness of the ferroelectric layer is from 3 nm to 20 nm. In this way, a ferroelectric polarity reversal can be implemented to store data, and a large device size caused by an excessive thickness of the film layer can be also avoided.

In an optional implementation, a thickness of at least one of the first electrode and the second electrode is from 5 nm to 100 nm. In this way, an effective electric field strength can be provided for the memory capacitor, and a large device size caused by an excessive thickness of the film layer can be also avoided.

According to another aspect of this application, a memory cell is provided. The memory cell may include a transistor and a memory capacitor electrically connected to the transistor. The memory capacitor includes a first metal oxide layer, a ferroelectric layer, and a second metal oxide layer. A dielectric constant of the first metal oxide layer is greater than a dielectric constant of the ferroelectric layer. The ferroelectric layer is stacked on the first metal oxide layer. The ferroelectric layer is a doped hafnium oxide-based ferroelectric layer. The first metal oxide layer may be configured to stretch a crystal structure of the ferroelectric layer, so that the crystal structure of the ferroelectric layer has a lattice distortion. The first metal oxide layer includes a first metal oxide, and a metal element in the first metal oxide includes at least one metal element from group III, group IV, or group V element, excluding hafnium. In addition, the second metal oxide layer is stacked on a side that is of the ferroelectric layer and that is away from the first metal oxide layer. A dielectric constant of the second metal oxide layer is greater than a dielectric constant of the ferroelectric layer, and the second metal oxide layer may be configured to stretch a crystal structure of the ferroelectric layer, so that the crystal structure of the ferroelectric layer has a lattice distortion. The second metal oxide layer includes a second metal oxide, and a metal element in the second metal oxide includes at least one metal element from group III, group IV, or group V element, excluding hafnium. Technical effect of the first metal oxide layer and the second metal oxide layer is the same as that described above. Details are not described herein again. In addition, the dielectric constant of the first metal oxide layer and the dielectric constant of the second metal oxide layer may be greater than the dielectric constant of the ferroelectric layer. In this case, the first metal oxide layer and the second metal oxide layer may be electrically conductive, so that the electrodes do not need to be disposed in the memory capacitor. In this way, a thickness of the device can be reduced, which is conducive to a design trend of product miniaturization.

In an optional implementation, the memory capacitor includes a plurality of first metal oxide layers: a first bottom metal oxide layer and a first top metal oxide layer. The first top metal oxide layer is stacked on a side that is of the first bottom metal oxide layer and that is away from the first electrode. A material of the first top metal oxide layer is different from a material of the first bottom metal oxide layer. Technical effect of the first bottom metal oxide layer and the first top metal oxide layer is same as that of the first metal oxide layer. Details are not described herein again. In an optional implementation, the first metal oxide includes at least one of lanthanum oxide, cerium oxide, titanium oxide, niobium oxide, tantalum oxide, or vanadium oxide. Beneficial effect of the material of the first metal oxide layer is the same as that described above. Details are not described herein again.

According to another aspect of this application, a memory array is provided, and includes a first electrode line, a second electrode line, a third electrode line, and any one of the foregoing memory cells. A control end of the transistor is electrically connected to the first electrode line, a first electrode of the transistor is electrically connected to the second electrode line, and a second electrode of the transistor is electrically connected to the third electrode line through the memory capacitor. The memory array has same technical effect as the memory cell provided in the foregoing embodiments. Details are not described herein again.

According to another aspect of this application, a memory array is provided, and includes a second electrode line, a third electrode line, and a memory capacitor. The memory capacitor may include a first electrode, a ferroelectric layer, a first metal oxide layer, and a second electrode. The first electrode is electrically connected to the second electrode line, and the second electrode is electrically connected to the third electrode line. The ferroelectric layer is stacked with the first electrode, where the ferroelectric layer is a doped hafnium oxide-based ferroelectric layer. The first metal oxide layer is stacked between the first electrode and the ferroelectric layer. The first metal oxide layer may be configured to stretch a crystal structure of the ferroelectric layer, so that the crystal structure of the ferroelectric layer has a lattice distortion. The first metal oxide layer includes a first metal oxide, and a metal element in the first metal oxide may include at least one metal element from group III, group IV, or group V element, excluding hafnium. In addition, the second electrode is stacked on a side that is of the ferroelectric layer and that is away from the first electrode. The memory array has same technical effect as the memory cell provided in the foregoing embodiments. Details are not described herein again.

In an optional implementation, the first metal oxide includes at least one of yttrium oxide, scandium oxide, lanthanum oxide, cerium oxide, titanium oxide, niobium oxide, tantalum oxide, or vanadium oxide. In this way, the first metal oxide can be selected from non-radioactive elements in the group III, group IV, and group V elements, thereby facilitating material acquisition.

In an optional implementation, a dielectric constant of the first metal oxide layer is greater than a dielectric constant of the ferroelectric layer, and the dielectric constant of the first metal oxide layer is less than a dielectric constant of the first electrode. In this way, the first metal oxide layer has a strong charge storage capability. When an operating voltage is applied to two sides of the ferroelectric layer, voltage division of the first metal oxide layer on the operating voltage can be reduced, so that a voltage actually applied to the ferroelectric layer is equivalent to the operating voltage, thereby improving utilization of the operating voltage and reducing power consumption.

In an optional implementation, the first metal oxide includes at least one of lanthanum oxide, cerium oxide, titanium oxide, niobium oxide, tantalum oxide, or vanadium oxide. A dielectric constant of the material is greater than the dielectric constant of the ferroelectric layer, and is less than the dielectric constant of the second electrode. According to another aspect of this application, a memory is provided, and includes a controller and any one of the foregoing memory arrays. The controller is electrically connected to the memory array, and the controller is configured to control read/write of the memory array. The memory has same technical effect as the memory array provided in the foregoing embodiments. Details are not described herein again.

In an optional implementation, the memory includes at least one of a ferroelectric memory, a ferroelectric field effect transistor, or a ferroelectric tunnel junction.

According to another aspect of this application, an electronic device is provided, and includes a circuit board and the foregoing memory. The circuit board is electrically connected to the memory. The electronic device has same technical effect as the memory provided in the foregoing embodiments. Details are not described herein again.

### BRIEF DESCRIPTION OF DRAWINGS

FIG. 1 is a diagram of a structure of an electronic device according to an embodiment of this application;
FIG. 2 is a diagram of a structure of a memory in FIG. 1;
FIG. 3 is a diagram of another structure of a memory in FIG. 1;
FIG. 4 is a diagram of a structure of a memory cell in FIG. 3;
FIG. 5A is a diagram of a structure of a memory capacitor in FIG. 4;
FIG. 5B is a diagram of a structure of a memory array according to an embodiment of this application;
FIG. 5C is a diagram of a structure of a FeFET according to an embodiment of this application;
FIG. 6A to FIG. 6D are respectively diagrams of different structures of a transistor and a capacitor that are electrically connected in FIG. 4;
FIG. 7 is a diagram of a structure of a memory capacitor according to a related technology;
FIG. 8A and FIG. 8B are respectively diagrams of a lattice structure before and after stretching;
FIG. 9A and FIG. 9B are respectively diagrams of another lattice structure before and after stretching;
FIG. 10A and FIG. 10B are respectively diagrams of a stretched unit cell structure and a stretched weighted-averaging unit cell structure;
FIG. 11A and FIG. 11B are respectively diagrams of a stretched unit cell structure and a stretched weighted-averaging unit cell structure;
FIG. 12 is a diagram of a polarization curve according to an embodiment of this application;
FIG. 13 is a diagram of another structure of a memory capacitor in FIG. 4;
FIG. 14 is a diagram of a polarization curve according to a related technology;
FIG. 15 is a diagram of another polarization curve according to an embodiment of this application;
FIG. 16 is a diagram of breakdown of a ferroelectric layer according to an embodiment of this application;
FIG. 17 is a curve diagram of a relationship between electric field strengths and currents of ferroelectric layers with different thicknesses according to an embodiment of this application;
FIG. 18 is a curve diagram of a relationship between a quantity of ferroelectric polarity reversals and a memory window according to an embodiment of this application;
FIG. 19 is another curve diagram of a relationship between a quantity of ferroelectric polarity reversals and a memory window according to an embodiment of this application;
FIG. 20A is another curve diagram of a relationship between a quantity of ferroelectric polarity reversals and a memory window according to an embodiment of this application;
FIG. 20B is another curve diagram of a relationship between a quantity of ferroelectric polarity reversals and a memory window according to an embodiment of this application;
FIG. 20C is another curve diagram of a relationship between a quantity of ferroelectric polarity reversals and a memory window according to an embodiment of this application;
FIG. 21A and FIG. 21B are respectively diagrams of a polarization curve before and after stretching;
FIG. 22A and FIG. 22B are respectively diagrams of another polarization curve before and after stretching;
FIG. 23A is a diagram of another structure of a memory capacitor in FIG. 4;
FIG. 23B is a diagram of another structure of a memory capacitor in FIG. 4;
FIG. 23C is a diagram of another structure of a memory capacitor in FIG. 4;
FIG. 24A is a diagram of another structure of a memory capacitor in FIG. 4;
FIG. 24B is a diagram of another structure of a memory capacitor in FIG. 4;
FIG. 25 is a diagram of another structure of a memory capacitor in FIG. 4; and
FIG. 26 is a diagram of another structure of a memory capacitor in FIG. 4.

Reference numerals:
100: electronic device; 101: bus; 102: SoC; 103: second RAM; 104: communication chip; 105: power management chip; 112: AP; 122: GPU; 132: first RAM; 20: memory; 21: memory array; 22: controller; 210: memory cell; 220: decoder; 230: driver; 240: timing controller; 250: cache; 260: input/output driver; 30: ferroelectric layer; 31: first electrode; 32: second electrode; 33: first metal oxide layer; 34: second metal oxide layer; 331: first bottom metal oxide layer; 332: first top metal oxide layer; 341: second bottom metal oxide layer; 342: second top metal oxide layer; 35: first transition layer; and 36: second transition layer.

### DESCRIPTION OF EMBODIMENTS

The following describes technical solutions in embodiments of this application with reference to the accompanying drawings in embodiments of this application. It is clear that the described embodiments are merely a part rather than all of embodiments of this application.

The terms such as "first" and "second", below are merely for convenience of description, and are not to be construed as indicating or implying relative importance or implicitly indicating a quantity of indicated technical features. Therefore, a feature limited by "first", "second", or the like may explicitly or implicitly include one or more features. In the descriptions of this application, unless otherwise stated, "a plurality of" means two or more than two.

In this application, unless otherwise expressly specified and limited, the term "connection" should be understood in a broad sense. For example, "connection" may be a fixed mechanical connection, or may be a detachable mechanical connection or an integrated connection. Alternatively, "connection" may be a direct connection, or may be an indirect connection via an intermediate medium.

In addition, unless otherwise expressly specified and limited, the term "electrical connection" should be understood in a broad sense. For example, "electrical connection" may be a direct electrical connection, for example, two components are physically in contact and electrically connected; or may be understood as that in a line structure, different components are electrically connected through a physical line that can transmit an electrical signal, such as a printed circuit board (printed circuit board, PCB) copper foil or a conducting wire, to transmit an electrical signal. Alternatively, "electrical connection" may be an indirect electrical connection between two components via an intermediate medium. Alternatively, "electrical connection" may be an electrical connection between two components in a separated/non-contact manner. For example, two components are electrically connected in a capacitive coupling manner, to transmit an electrical signal.

In embodiments of this application, orientation terms such as "upper" and "lower" may include but are not limited to being defined relative to placement orientations of components shown in the accompanying drawings. It should be understood that these directional terms may be relative concepts and are used for relative descriptions and clarifications, and may vary accordingly based on changes of the placement orientations of the components in the accompanying drawings.

Embodiments of this application provide an electronic device. The electronic device may be applied to various communication systems or communication protocols, for example, a Bluetooth (Bluetooth, BT) communication technology, a global positioning system (global positioning system, GPS) communication technology, a global system for mobile communications (global system of mobile communications, GSM) communication technology, a wireless fidelity (wireless fidelity, Wi-Fi) communication technology, a wideband code division multiple access (wideband code division multiple access wireless, WCDMA) communication technology, long term evolution (long term evolution, LTE), a 5G communication technology, and another future communication technology. The electronic device in embodiments of this application may be a mobile phone, a tablet computer (pad), a notebook computer, a smart home, a smart wearable device (for example, a smartwatch, a smart band, smart glasses, or a smart helmet), a virtual reality (virtual reality, VR) electronic device, an augmented reality (augmented reality, AR) electronic device, or the like. Alternatively, the electronic device may be a handheld device that has a wireless communication function, a compute device or another processing device connected to a wireless modem, a vehicle-mounted device, an electronic device in a 5G network, an electronic device in a future evolved public land mobile network (public land mobile network, PLMN), or the like. This is not limited in embodiments of this application.

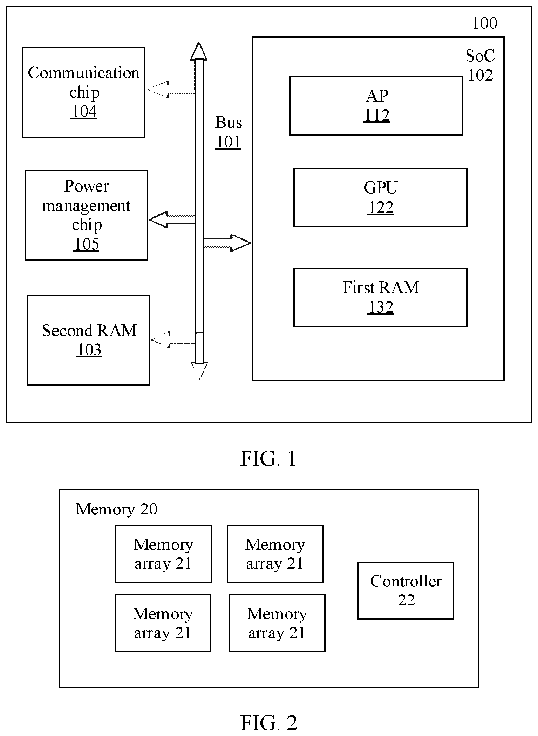

For example, as shown in FIG. 1, the electronic device 100 may include a circuit board (for example, the PCB), a bus 101 disposed on the PCB and electrically connected to the PCB, and a processor connected to the bus 101, for example, a system on chip (system on chip, SoC) 102. The SoC 102 may be configured to process data, for example, process data of an application, process image data, and cache temporary data. In an implementation, the SoC 102 may include an application processor (application processor, AP) 112 configured to process the application, a graphics processing unit (Graphics Processing Unit, GPU) 122 configured to process the image data, and a first RAM 132 configured to cache high-speed data. The first RAM 132 may be a static random access memory (static random access memory, SRAM), an embedded flash (embedded flash, eflash), or the like. The AP 112, the GPU 122, and the first RAM 132 may be integrated into one die (die), or may be separately disposed in a plurality of dies.

In addition, still as shown in FIG. 1, the electronic device 100 may further include a second RAM 103 connected to the SoC 102 through the bus 101. The second RAM 103 may be a dynamic random access memory (dynamic random access memory, DRAM). The second RAM 103 may be configured to store volatile data, for example, temporary data generated by the SoC 102. A memory capacity of the second RAM 103 may be usually greater than that of the first RAM 132, but a read speed of the second RAM 103 is usually slower than that of the first RAM 132. In addition, the electronic device 100 may further include a communication chip 104 and a power management chip 105 that are connected to the SoC 102 through the bus 101. The communication chip 104 may be configured to process a protocol stack, or perform processing such as amplification and filtering on an analog radio frequency signal, or implement the foregoing functions at the same time. The power management chip 105 may be configured to supply power to another chip. In an implementation, the SoC 102 and the second RAM 103 may be packaged in a packaging structure, for example, 2.5D (dimension) or 3D packaging is used, to obtain a faster inter-chip data transmission rate.

In this case, the memory in the electronic device 100 provided in this embodiment of this application may be a ferroelectric memory, and the ferroelectric memory may be the first RAM 132 or the second RAM 103 in FIG. 1. An application scenario of the ferroelectric memory is not limited in this application. In view of this, as shown in FIG. 2, the memory 20 may include a memory array 21 and a controller 22 configured to access the memory array 21. The controller 22 is electrically connected to the memory array 21, and the controller 22 may be configured to control a read/write operation of the memory array 21.

For example, in the memory 20, the memory array 21 and the controller 22 may be two dies (die) independent of each other. The memory array 21 and the controller 22 may be separately disposed on a bearing plate (for example, a package substrate or an adapter plate), and the memory array 21 and the controller 22 are separately electrically connected to the bearing plate. In this way, the memory array 21 and the controller 22 can implement signal transmission through a metal trace in the bearing plate. In view of this, the memory 20 having the memory array 21 may be referred to as a stand-alone (stand-alone) memory.

Alternatively, for another example, in the memory 20, the memory array 21 and the controller 22 may be two dies (die) independent of each other, and the memory array 21 and the controller 22 are stacked on the bearing plate. The memory array 21 and the controller 22 may be electrically connected through a through silicon via (through silicon via, TSV) or a redistribution layer (redistribution layer, RDL), so that the memory array 21 and the controller 22 can perform signal transmission with the bearing plate. Similarly, the memory array 21 is the stand-alone memory.

Alternatively, for another example, in the memory 20, the memory array 21 and the controller 22 may be integrated into a same chip, and the integrated chip is electrically connected to the bearing plate. In view of this, the memory 20 having the memory array 21 may be referred to as an embedded memory.

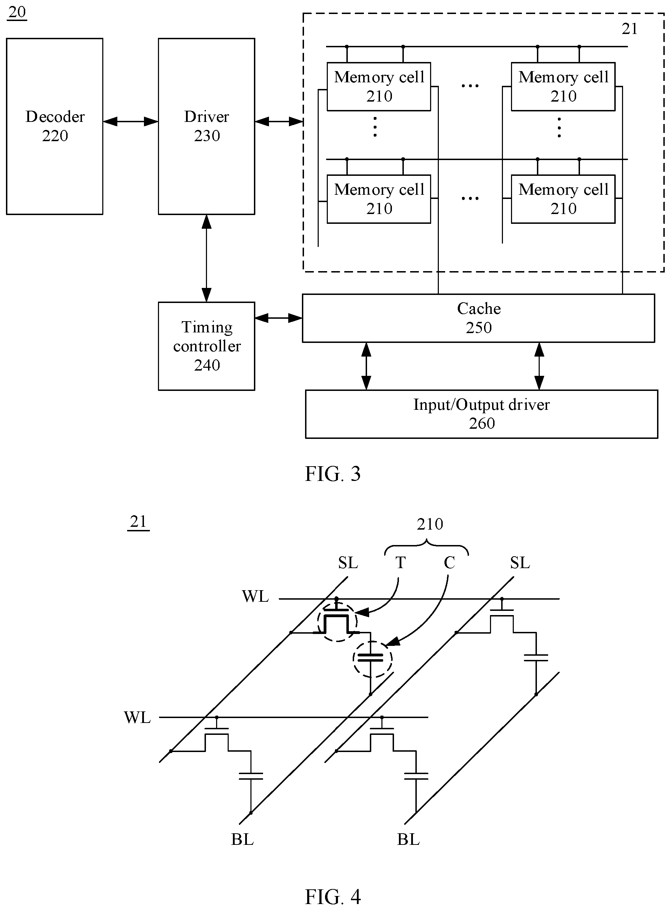

On this basis, as shown in FIG. 3, the memory array 21 may include a plurality of memory cells 210 arranged in an array, and each memory cell 210 may be configured to store 1-bit (bit) or multi-bit data. The memory array 21 may further include a word line (word line, WL), a bit line (bit line, BL), a source line (source line, SL), and a precharge line CL (not shown in the figure) shown in FIG. 4. Each memory cell 210 is electrically connected to a corresponding word line WL, a bit line BL, a source line SL, and a precharge line CL.

For example, when the memory 20 is a ferroelectric random access memory (ferroelectric random access memory, FeRAM, or FRAM), in the memory array 21 of the memory 20, the memory cell 210 may include a transistor T and a memory capacitor C electrically connected to the transistor T. The transistor T may be a metal-oxide-semiconductor field-effect transistor (metal-oxide-semiconductor field-effect transistor, MOSFET). For each memory cell 210, a control end (for example, a gate of T) of the transistor T may be electrically connected to a first electrode line, for example, the word line WL, a first electrode (for example, a source) of the transistor T may be electrically connected to a second electrode line, for example, the source line (source line, SL), and a second electrode (for example, a drain) of the transistor T may be electrically connected to a third electrode line, for example, the bit line BL, through the memory capacitor C. For example, the second electrode of the transistor T may be electrically connected to one electrode of the memory capacitor C, and the other electrode of the memory capacitor C may be electrically connected to the third electrode line, for example, the BL.

Different memory cells 210 may be electrically connected through a WL, a BL, an SL, or a CL. One or more of the WL, the BL, the SL, and the CL are configured to select, by receiving a control level output by a control circuit, a to-be-read/written memory cell 210 in the memory array 21, to change a polarization direction of the memory capacitor C in the memory cell 210, to implement a data read/write operation. In addition, transistors T of the plurality of memory cells 210 may be electrically connected to a same electrode line (for example, a word line WL). When these memory cells perform a read/write operation, a voltage may be applied to a gate of the transistor T through a word line WL, so that the plurality of transistors T may be simultaneously conducted or cut off. When the transistor T is conducted, and a voltage difference is formed between the SL and the BL, a voltage difference may be generated between two ends of the memory capacitor C electrically connected to the conducted transistor T, so that a polarization direction (upward polarization or downward polarization) of a ferroelectric material in the memory capacitor C can be changed. A state corresponding to the two polarization directions may be identified as a state of stored information "0" or "1", thereby implementing a read operation of data stored in the memory capacitor C.

FIG. 4 is merely an example for description in which the memory cell 210 of the memory array 21 is 1T1C (that is, one transistor T and one memory capacitor C). A quantity of transistors and a quantity of memory capacitors in the memory cell 210 are not limited in this embodiment of this application. In addition, the controller 22 in FIG. 2 may include one or more circuit structures in a decoder 220, a driver 230, a timing controller 240, a cache 250, or an input/output driver 260 shown in FIG. 3. The decoder 220 is configured to decode an address of the memory cell 210. The decoder 220 is configured to perform decoding based on a received address, to determine a memory cell 210 that needs to be accessed. The driver 230 is configured to control a level of a signal line based on a decoding result generated by the decoder 220, to access the specified memory cell 210. The cache 250 is configured to cache read data, for example, may cache the data in a first-in first-out (first-in first-out, FIFO) manner. The timing controller 240 is configured to: control timing of the cache 250, and control timing of the driver 230 for driving a signal line in the memory cell 210. The input/output driver 260 is configured to drive a transmission signal, for example, drive a received data signal and drive a data signal that needs to be sent, so that the data signals can be transmitted over a long distance. The memory array 21, the decoder 220, the driver 230, the timing controller 240, the cache 250, and the input/output driver 260 may be integrated into one chip, or may be respectively integrated into a plurality of chips.

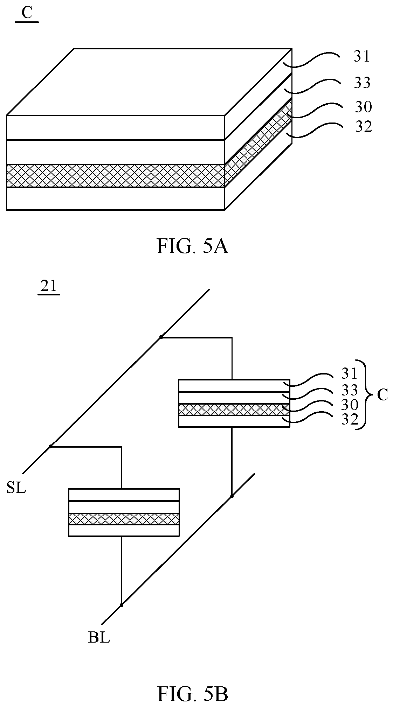

The following describes a structure of the memory capacitor C in the memory cell 210 by using an example. In some embodiments of this application, the memory capacitor C may include a first electrode 31, a second electrode 32, and a ferroelectric layer 30 shown in FIG. 5A. The ferroelectric layer 30 may be disposed between the first electrode 31 and the second electrode 32. In addition, the memory capacitor C may further include a first metal oxide layer 33. The first metal oxide layer 33 is stacked between the first electrode 31 and the ferroelectric layer 30, and the second electrode 32 is stacked on a side that is of the ferroelectric layer 30 and that is away from the first electrode 31.

In this case, the first electrode 31 and the second electrode 32 may be used as two electrodes of the memory capacitor C. When there is a voltage difference between the first electrode 31 and the second electrode 32, a polarization direction (upward polarization or downward polarization) of a ferroelectric material in the ferroelectric layer 30 may be changed, to implement a read operation of data stored in the memory capacitor C.

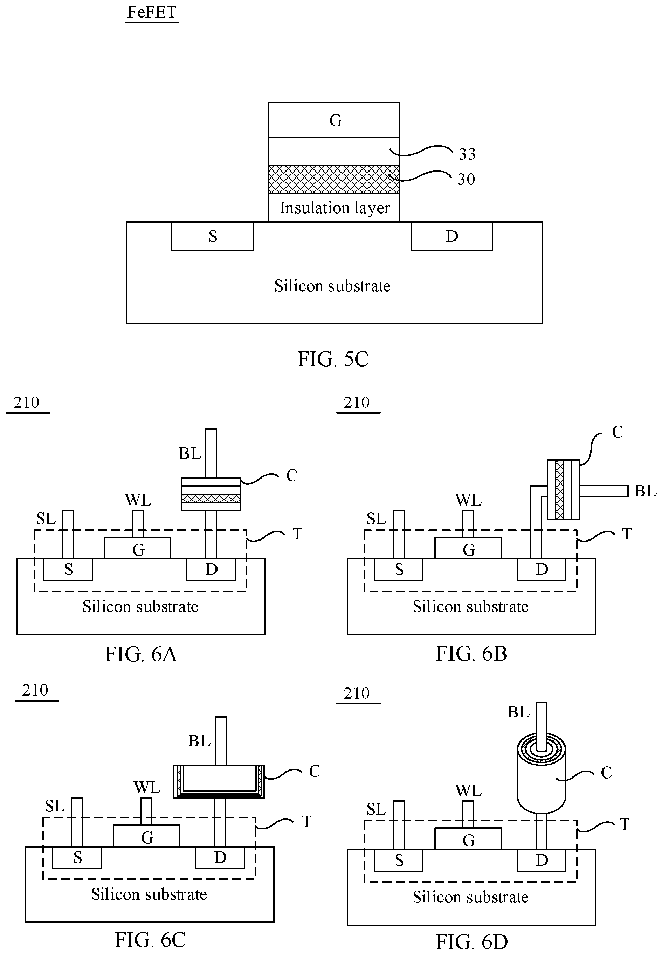

For example, the memory having the memory capacitor C is the FeRAM. In some embodiments of this application, as shown in FIG. 6A, the memory capacitor C may be a planar capacitor. The first electrode 31, the first metal oxide layer 33, the ferroelectric layer 30, and the second electrode 32 that are stacked in the memory capacitor C may all be parallel to a surface of a substrate (for example, a silicon substrate) on which a transistor T is manufactured.

FIG. 6A is described by using an example in which a source (source, S) of the transistor T is electrically connected to a source line SL, one electrode of the memory capacitor C, for example, the second electrode 32 shown in FIG. 5A, is electrically connected to a drain (drain, D) of the transistor T, the other electrode of the memory capacitor C, for example, the first electrode 31 shown in FIG. 5A, is electrically connected to a bit line BL, and a gate (gate, G) of the transistor T is electrically connected to a word line WL. This does not constitute a limitation on the electrical connection manner between the transistor T and the memory capacitor C. In the following accompanying drawings, the electrical connection manner between the transistor T and the memory capacitor C is similar to the electrical connection manner shown in FIG. 6A. Details are not described again below.

In some other embodiments of this application, as shown in FIG. 6B, the memory capacitor C may be a vertical fin capacitor. The first electrode 31, the first metal oxide layer 33, the ferroelectric layer 30, and the second electrode 32 that are stacked in the memory capacitor C may all be perpendicular to a surface of a substrate (for example, a silicon substrate) on which the transistor T is manufactured. Alternatively, as shown in FIG. 6C, the memory capacitor C may be a three-dimensional trench capacitor. Alternatively, as shown in FIG. 6D, the memory capacitor C may be a three-dimensional annular capacitor. The foregoing is merely an example of the structure of the memory capacitor C, and does not constitute a limitation on the structure of the memory capacitor C. In addition, in the memory array 21 provided in this embodiment of this application, the ferroelectric layer 30 shown in FIG. 5A may be a doped hafnium oxide (HfO₂)-based ferroelectric layer. The ferroelectric layer in the related technology usually uses a perovskite structure material such as lead zirconium titanate (lead zirconium titanate), lead zirconate (PbZrO₃), lead titanate (PbTiO₃), or lead zirconate titanate piezoelectric (PZT) ceramic. The perovskite structure material needs to be above a critical thickness to reflect stable ferroelectricity, and therefore cannot be compatible with a requirement of advanced manufacturing for size miniaturization.

In comparison, in this embodiment of this application, because the doped hafnium oxide (HfO₂)-based ferroelectric material has good compatibility with a complementary metal oxide semiconductor (complementary metal oxide semiconductor, CMOS) process, the ferroelectric layer 30 can be prepared in a thin film deposition manner such as physical vapor deposition (physical vapor deposition, PVD), chemical vapor deposition (chemical vapor deposition, CVD), or atomic layer deposition (atomic layer deposition, ALD). In addition, the doped hafnium oxide (HfO₂)-based ferroelectric material has a lower crystallization temperature and a miniaturization capability limit below 5 nm, thus facilitating preparing a non-volatile memory with low power consumption, high reliability, and high density.

Still as shown in FIG. 5A, the first metal oxide layer 33 may be configured to stretch a crystal structure of the ferroelectric layer 30, so that the crystal structure of the ferroelectric layer 30 has a lattice distortion. The first metal oxide layer 33 may include a first metal oxide, and a metal element in the first metal oxide may include at least one metal element in a group III (III), group IV (IV), or group V (V) element other than a hafnium (Hf) element.

For example, the metal element of the first metal oxide in the first metal oxide layer 33 may include at least one of scandium (Sc), yttrium (Y), lanthanum (La), or cerium (Ce) in the group III element, or titanium (Ti) or zirconium (Zr) in the group IV element, or niobium (Nb), tantalum (Ta), or vanadium (V) in the group V element. In this way, the metal element of the first metal oxide in the first metal oxide layer 33 can be selected from non-radioactive elements in the group III (III), group IV (IV), or group V (V) element, thereby facilitating material acquisition.

In view of this, for example, the first metal oxide in the first metal oxide layer 33 may include at least one of yttrium oxide (for example, Y₂O₃), scandium oxide (for example, Sc₂O₃), lanthanum oxide (for example, La₂O₃), cerium oxide (for example, CeO₂), titanium oxide (for example, TiO₂), zirconium oxide (for example, ZrO₂), niobium oxide (for example, Nb₂O₅), tantalum oxide (Ta₂O₅), or vanadium oxide (for example, V₂O₅).

In this case, because the metal element of the first metal oxide in the first metal oxide layer 33 may include the at least one metal element in the group III (III), group IV (IV), or group V (V) element other than the hafnium (Hf) element, a lattice structure of the first metal oxide layer 33 after crystallization is similar to a lattice structure of the ferroelectric layer 30 after crystallization, so that a chemical bond is easily formed near an interface between the first metal oxide layer 33 and the ferroelectric layer 30. In addition, in a process of converting the first metal oxide layer 33 and the ferroelectric layer 30 from an amorphous structure to the crystal structure, the first metal oxide layer 33 may stretch the crystal structure of the ferroelectric layer 30, so that a proper stress is generated near the interface between the first metal oxide layer 33 and the ferroelectric layer 30. The stress may cause a mismatch (lattice mismatch) between the lattice of the ferroelectric layer 30 and the lattice of the first metal oxide layer 33, to form a dislocation (namely, a mismatch dislocation), so that the lattice structure of the ferroelectric layer 30 has a lattice distortion.

In view of this, when the metal element of the first metal oxide included in the first metal oxide layer 33 includes the at least one metal element in the group III (III), group IV (IV), or group V (V) element other than the hafnium (Hf) element, an excessive or insufficient stress generated near the interface between the first metal oxide layer 33 and the ferroelectric layer 30 in the crystallization process may prevent formation of the lattice distortion.

The foregoing describes a structure of the memory capacitor C by using an example in which the memory 20 is the FeRAM, and the memory cell 210 in the memory 20 includes the transistor T and the memory capacitor C electrically connected to the transistor T.

In some other embodiments of this application, the memory 20 may be a ferroelectric tunnel junction (ferroelectric tunnel junction, FTJ) memory. For example, a memory array 21 of the memory is shown in FIG. 5B, and may include a second electrode line like an SL, a third electrode line like a BL, and a memory capacitor C. The second electrode line, for example, the SL, may be electrically connected to a first electrode 31 of the memory capacitor C, and the third electrode line, for example, the BL, may be electrically connected to a second electrode 32 of the memory capacitor C. Materials and technical effect of the ferroelectric layer 30 and the first metal oxide layer 33 in the memory capacitor C are the same as those described above. Details are not described herein again.

In addition, some other embodiments of this application may further provide a ferroelectric field effect transistor (ferroelectric field effect transistor, FeFET) shown in FIG. 5C. A source (S) region and a drain (D) region of the FeFET may be formed on a silicon substrate. In addition, the first metal oxide layer 33, the ferroelectric layer 30, and an insulation layer (for example, SiO₂) may be sequentially disposed below a gate (G) of the FeFET. Materials and technical effect of the ferroelectric layer 30 and the first metal oxide layer 33 are the same as those described above. Details are not described herein again.

For ease of description, the following describes a structure of the memory capacitor C in the memory 20 by using an example in which the memory 20 is the FeRAM.

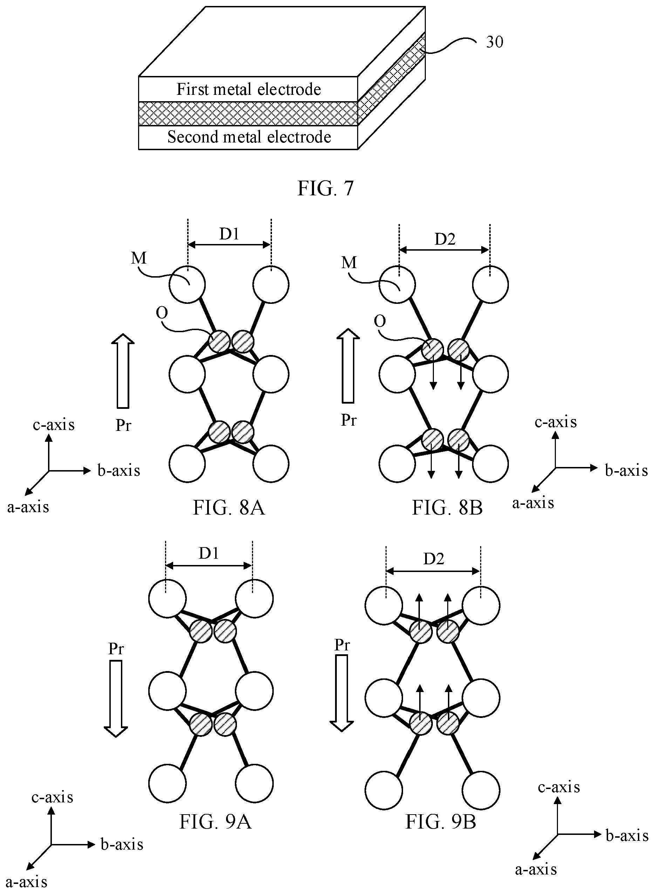

With reference to a structure of a memory capacitor in which the first metal oxide layer is not disposed shown in FIG. 7, the following describes, by using an example, a process in which the ferroelectric layer 30 has a lattice distortion under stretching action of the first metal oxide layer 33 shown in FIG. 5A. The memory capacitor shown in FIG. 7 includes a first metal electrode, a ferroelectric layer 30, and a second metal electrode that are stacked.

In view of this, for example, FIG. 8A and FIG. 8B are described by using an example in which a polarization (pr) direction of the ferroelectric material in the ferroelectric layer 30 is upward, and each oxygen atom O is connected to a metal atom M near the oxygen atom O by using three chemical bonds. FIG. 8A shows a lattice structure of the ferroelectric layer 30 after crystallization when the first metal oxide layer is not disposed in the memory capacitor C. In this case, in a b-axis direction of the crystal structure, a spacing between two adjacent metal atoms M is D1. In comparison, FIG. 8B indicates that under stretching action of the first metal oxide layer 33 shown in FIG. 5A, the ferroelectric material in the ferroelectric layer 30 undergoes a mismatch dislocation, causing the b-axis of the crystal structure to be stretched, and a distance between two adjacent metal atoms M is increased from D1 to D2, so that the crystal structure of the ferroelectric layer 30 has a lattice distortion.

In this case, still as shown in FIG. 8B, because a lower part of each oxygen atom O is separately connected to two metal atoms M by using two chemical bonds, and an upper part of the oxygen atom O is connected to one metal atom M by using one chemical bond, the lower metal atom M exerts a larger stretching force on the oxygen atom O. In view of this, when the spacing between the two adjacent metal atoms M is increased from D1 to D2, under an action of the metal atom M, the oxygen atom O may move downward, to be closer to the lower metal atom M.

Alternatively, for another example, FIG. 9A and FIG. 9B are described by using an example in which a polarization (pr) direction of the ferroelectric material in the ferroelectric layer 30 is downward, and each oxygen atom O is connected to a metal atom M near the oxygen atom O by using three chemical bonds. FIG. 9A shows a lattice structure of the ferroelectric layer 30 after crystallization when the first metal oxide layer 33 is not disposed in the memory capacitor C. In this case, in a b-axis direction of the crystal structure, a spacing between two adjacent metal atoms M is D1. In comparison, FIG. 9B indicates that under stretching action of the first metal oxide layer 33 shown in FIG. 5A, the ferroelectric material in the ferroelectric layer 30 undergoes a mismatch dislocation, causing a distance between two adjacent metal atoms M to be increased from D1 to D2 in the b-axis direction of the crystal structure, so that the crystal structure of the ferroelectric layer 30 has a lattice distortion. Similarly, when the spacing between the two adjacent metal atoms M is increased from D1 to D2, under an action of the metal atom M, the oxygen atom O may move upward, to be closer to the upper metal atom M.

Therefore, it can be learned from the foregoing description that, under the stretching action of the first metal oxide layer 33 on the crystal structure of the ferroelectric layer 30, the b-axis of the crystal structure is stretched, so that the oxygen atom O is closer to the metal atom M on one side, causing a lattice distortion in the lattice structure, thereby making the lattice structure more asymmetric. The doped hafnium oxide-based ferroelectric material exhibits a monoclinic (monoclinic, M) phase, a tetragonal (tetragonal, T) phase, and an orthorhombic (orthorhombic, O) phase. The monoclinic (monoclinic, m) phase and the tetragonal (tetragonal, t) phase are centrosymmetric to the atom, and therefore do not exhibit ferroelectricity. The O phase is a main reason for generating ferroelectricity of the doped hafnium oxide-based ferroelectric material. Therefore, under the stretching action of the first metal oxide layer 33, a proportion of the O phase in the lattice structure of the ferroelectric layer 30 having the lattice distortion is increased, thereby increasing ferroelectricity of the ferroelectric layer 30.

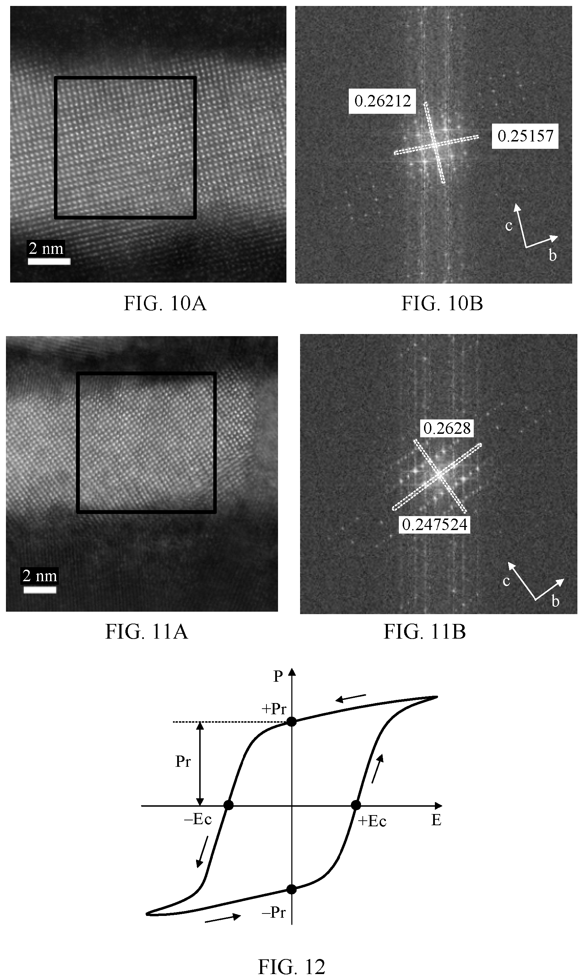

The crystal structure may be described by using a lattice and a unit cell. The lattice refers to a periodic arrangement pattern of atoms or molecules, while the unit cell is a smallest repetitive unit. The unit cell may be described using three mutually perpendicular coordinate axes, namely, the a-axis, b-axis, and c-axis. In this embodiment of this application, the c-axis may be parallel to an electric field direction of the memory capacitor C (that is, a direction in which the first electrode 31 points to the second electrode 32 in FIG. 5A, or a direction in which the second electrode 32 points to the first electrode 31 in FIG. 5A). Directions of the a-axis and the b-axis are not limited in this application. The following describes an example in which the b-axis of the crystal structure of the ferroelectric layer 30 is stretched under the action of the first metal oxide layer 33. For example, in FIG. 10A, the "black square region" includes a plurality of unit cells of the ferroelectric layer 30 having a lattice distortion under the stretching action of the first metal oxide layer 33. In FIG. 10B, an electron diffraction pattern in the "black square region" shown in FIG. 10A is calibrated to determine a crystal structure and measure a lattice constant. FIG. 10B shows that a length of the b-axis is 0.25157 and a length of the c-axis is 0.26212. Through scale conversion, it may be obtained that, as shown in Table 1, a b-axis lattice constant of the ferroelectric layer 30 provided in this embodiment of this application is 5.0314 Å, and a c-axis lattice constant is 5.2424 Å.

In addition, in FIG. 11A, the "black square region" includes a plurality of unit cells of the ferroelectric layer 30 after crystallization when the first metal oxide layer 33 is not disposed in the memory capacitor C. In FIG. 11B, an electron diffraction pattern in the "black square region" shown in FIG. 11A is calibrated to determine a crystal structure and measure a lattice constant. FIG. 11B shows that a length of the b-axis is 0.247524 and a length of the c-axis is 0.2628. Similarly, through scale conversion, it may be obtained that when the first metal oxide layer 33 is not disposed in the memory capacitor C, as shown in Table 1, a b-axis lattice constant of the ferroelectric layer is 4.9505 Å, and a c-axis lattice constant is 5.2562 Å.

**Table 1**

| Coordinate axis | Lattice constant (not disposed with the first metal oxide layer) | Lattice constant (disposed with the first metal oxide layer) |
|---|---|---|
| b-axis | 4.9505 Å | 5.0314 Å |
| c-axis | 5.2562 Å | 5.2424 Å |

It can be learned from Table 1 that, when the first metal oxide layer 33 is disposed in the memory capacitor C, under stretching action of the first metal oxide layer 33 on the crystal structure of the ferroelectric layer 30, a b-axis of the crystal structure is stretched (which is increased from 4.9505 Å to 5.0314 Å), and the b-axis lattice constant is increased by about 2%. It can be learned from the foregoing that, this may cause the lattice structure of the ferroelectric layer 30 after the crystallization to have a lattice distortion, so that a proportion of the O phase in the lattice structure of the ferroelectric layer 30 is increased, thereby increasing ferroelectricity of the ferroelectric layer 30. The foregoing is merely an example for description in which the b-axis of the lattice structure of the ferroelectric layer 30 is stretched, thereby increasing the b-axis lattice constant, and does not constitute a limitation on an increase in the b-axis lattice constant. Compared with a solution in which no metal oxide layer that can cause a lattice distortion of the ferroelectric layer 30 is disposed in the memory capacitor C, in this embodiment of this application, the b-axis lattice constant of the ferroelectric layer 30 can be increased by 1% to 5%.

In view of this, on the one hand, it can be learned from a polarization (polarization voltage, PV) curve of the ferroelectric material after crystallization shown in FIG. 12 that a coercive field (coercive field, E_{C}) can reflect a polarity reversal difficulty of the ferroelectric material, and represent a reverse electric field strength required for restoring a polarization strength of the ferroelectric material to zero. Therefore, enhancement of the ferroelectricity of the ferroelectric layer 30 can make it easier to implement a polarity reversal of the ferroelectric layer 30, thereby reducing a coercive field E_{C} of the memory array 21 as shown in FIG. 12. Because the coercive field E_{C} is in direct proportion to an operating electric field and an operating voltage, the operating electric field and the operating voltage of the memory array 21 can be further reduced, thereby reducing power consumption of the memory array 21 and the memory 20 having the memory array 21. On the other hand, the ferroelectricity of the ferroelectric layer 30 is enhanced, and a crystallization level of the ferroelectric layer 30 can be further improved, thereby increasing a remanent polarization (remanent polarization, Pr) amount shown in FIG. 12, and enlarging a memory window of the memory 20.

In this case, to further improve the ferroelectricity of the ferroelectric layer 30, it can be learned from the foregoing that the ferroelectric layer 30 may be a doped hafnium oxide-based ferroelectric material, and the material may include hafnium oxide and a doping material. The doping material may include at least one of zirconium (Zr), titanium (Ti), niobium (Nb), lanthanum (La), cerium (Ce), gadolinium (Gd), yttrium (Y), aluminum (Al), or strontium (Sr). The elements may be doped to change symmetry of the crystal structure of the hafnium oxide-based ferroelectric material, or an appropriate amount of oxygen vacancies may be introduced to reduce an energy barrier of phase transition, thereby enhancing the ferroelectricity of the hafnium oxide-based ferroelectric material.

In addition, as shown in Table 1, when the first metal oxide layer 33 is disposed in the memory capacitor C, c-axis data of the crystal structure of the ferroelectric layer 30 does not change greatly. However, by comparing the c-axis shown in FIG. 10B with the c-axis shown in FIG. 11B, it can be learned that when the first metal oxide layer 33 is disposed in the memory capacitor C, as shown in FIG. 10B, the c-axis is more oriented toward a vertical direction. The vertical direction is a direction in which the second electrode 32 in the memory capacitor C points to the first electrode 31 (or a direction in which the first electrode 31 points to the second electrode 32), as shown in FIG. 5A, that is, an electric field direction of the memory capacitor C. In this way, an effective component of the ferroelectric polarization of the ferroelectric layer 30 in the electric field direction can be increased, thereby helping increase an actual remanent polarization pr amount of the memory, and improving the memory window.

On this basis, to further reduce an operating voltage of the memory 20, a dielectric constant (dielectric constant, also referred to as a K value) of the first metal oxide layer 33 may be greater than a dielectric constant of the ferroelectric layer 30, and the dielectric constant of the first metal oxide layer 33 may be less than a dielectric constant of the first electrode 31. That is, the dielectric constant of the first metal oxide layer 33 may be between the dielectric constant of the first electrode 31 and the dielectric constant of the ferroelectric layer 30.

For example, it can be learned from the foregoing that the first metal oxide in the first metal oxide layer 33 may include at least one of yttrium oxide (for example, Y₂O₃), scandium oxide (for example, Sc₂O₃), lanthanum oxide (for example, La₂O₃), cerium oxide (for example, CeO₂), titanium oxide (for example, TiO₂), zirconium oxide (for example, ZrO₂), niobium oxide (for example, Nb₂O₅), tantalum oxide (Ta₂O₅), or vanadium oxide (for example, V₂O₅). Dielectric constants of the materials that may be used as the first metal oxide of the first metal oxide layer 33, and dielectric constants of hafnium oxide (for example, HfO₂) and zirconium oxide (for example, ZrO₂) may be shown in Table 2.

**Table 2**

| Material | K value |
|---|---|
| Y₂O₃ | 15 |
| Sc₂O₃ | 14 to 17 |
| La₂O₃ | 30 |
| CeO₂ | 23 to 26 |
| TiO₂ | 80 |
| Nb₂O₅ | 40 to 200 |
| Ta₂O₅ | 26 |
| V₂O₅ | 36 |
| HfO₂ | 25 |
| ZrO₂ | 25 |

It can be learned from Table 2 that, the dielectric constant of yttrium oxide (for example, Y₂O₃) and the dielectric constant of scandium oxide (for example, Sc₂O₃) are less than the dielectric constant of hafnium oxide (for example, HfO₂). In addition, the dielectric constant of a zirconium (Zr) oxide, for example, ZrO₂, in the group IV (IV) element is the same as the dielectric constant of hafnium oxide (for example, HfO₂). Therefore, to make the dielectric constant of the first metal oxide layer 33 greater than the dielectric constant of the ferroelectric layer 30 and less than the dielectric constant of the first electrode 31, the first metal oxide in the first metal oxide layer 33 may include at least one of lanthanum oxide (for example, La₂O₃), cerium oxide (for example, CeO₂), titanium oxide (for example, TiO₂), niobium oxide (for example, Nb₂O₅), tantalum oxide (Ta₂O₅), or vanadium oxide (for example, V₂O₅).

In this way, the first metal oxide layer 33 has a strong charge storage capability. When an operating voltage is applied to two sides of the ferroelectric layer 30, voltage division of the first metal oxide layer 33 on the operating voltage can be reduced, so that a voltage actually applied to the ferroelectric layer 30 is equivalent to the operating voltage, thereby improving utilization of the operating voltage and reducing power consumption.

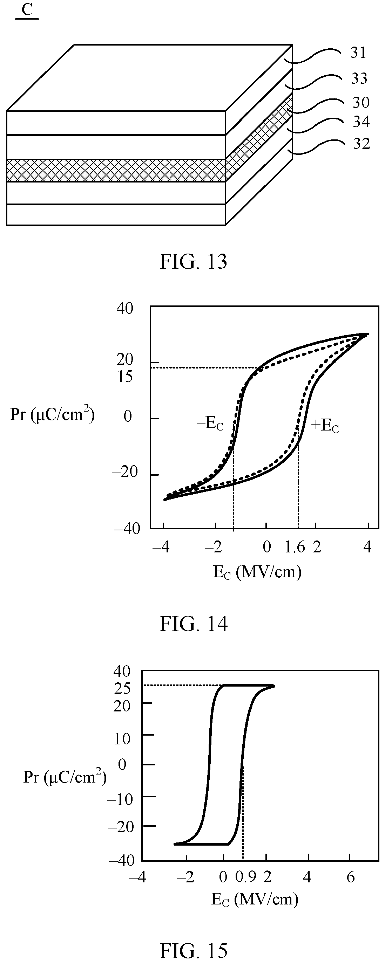

The foregoing description is provided by using an example in which the memory capacitor C has a metal oxide layer (namely, the first metal oxide layer 33) used to stretch the ferroelectric layer 30. In some other embodiments of this application, as shown in FIG. 13, the memory capacitor C may have two metal oxide layers: the first metal oxide layer 33 and the second metal oxide layer 34. The second metal oxide layer 34 may be stacked between the second electrode 32 and the ferroelectric layer 30. The second metal oxide layer 34 is configured to stretch a crystal structure of the ferroelectric layer 30, so that the crystal structure of the ferroelectric layer 30 has a lattice distortion. Therefore, the first metal oxide layer 33 and the second metal oxide layer 34 have a same function.

Similarly, the second metal oxide layer 34 may include a second metal oxide, and a metal element in the second metal oxide may include at least one metal element from group III, group IV, or group V element, excluding hafnium. For example, the second metal oxide in the second metal oxide layer 34 may include at least one of yttrium oxide (for example, Y₂O₃), scandium oxide (for example, Sc₂O₃), lanthanum oxide (for example, La₂O₃), cerium oxide (for example, CeO₂), titanium oxide (for example, TiO₂), zirconium oxide (for example, ZrO₂), niobium oxide (for example, Nb₂O₅), tantalum oxide (Ta₂O₅), or vanadium oxide (for example, V₂O₅).

In addition, to reduce voltage division of the second metal oxide layer 34 on the operating voltage applied to the ferroelectric layer 30, similarly, the second metal oxide in the second metal oxide layer 34 may include at least one of lanthanum oxide (for example, La₂O₃), cerium oxide (for example, CeO₂), titanium oxide (for example, TiO₂), niobium oxide (for example, Nb₂O₅), tantalum oxide (Ta₂O₅), or vanadium oxide (for example, V₂O₅).

In view of this, in a process of manufacturing the memory capacitor C shown in FIG. 13, the second electrode 32, the second metal oxide layer 34, the ferroelectric layer 30, the first metal oxide layer 33, and the first electrode 31 may be successively manufactured on the substrate by using a deposition process, for example, the thin film deposition manner such as PVD, CVD, or ALD. Materials of the first electrode 31 and the second electrode 32 may include at least one of tungsten (W), titanium (Ti), copper (Cu), aluminum (Al), ruthenium (Ru), platinum (Pt), iridium (Ir), tungsten nitride (WN), titanium nitride (TiN), tantalum nitride (TaN), or the like. In addition, materials of the first electrode 31 and the second electrode 32 may be the same or may be different. This is not limited in this application. For example, as shown in Table 3, materials of the first electrode 31 and the second electrode 32 may include tungsten (W) and titanium nitride (TiN) in Table 3, and thicknesses of the first electrode 31 and the second electrode 32 may be from 5 nm to 100 nm. When the thickness of the first electrode 31 and the thickness of the second electrode 32 are from 5 nm to 100 nm, an effective electric field strength can be provided for the memory capacitor C, and a large device size caused by an excessive thickness of the film layer can be also avoided. In addition, a material of the ferroelectric layer 30 may include zirconium-doped hafnium zirconium oxide (HZTO), and a thickness of the ferroelectric layer 30 may be from 3 nm to 20 nm. When the thickness of the ferroelectric layer 30 is from 3 nm to 20 nm, a ferroelectric polarity reversal can be implemented to store data, and a large device size caused by an excessive thickness of the film layer can be also avoided.

The foregoing is described by using an example in which both the first electrode 31 and the second electrode 32 of the memory capacitor C are made of a metal material. In this case, the memory capacitor C may be a metal-insulator-metal (metal-insulator-metal, MIM) capacitor structure formed by a metal-ferroelectric-metal (metal-ferroelectric-metal, MFM) material. Alternatively, in some other embodiments of this application, the memory capacitor C may alternatively use a metal-ferroelectric-semiconductor (metal-ferroelectric-semiconductor, MFS) structure, that is, at least one of the first electrode 31 and the second electrode 32 may use a semiconductor material. For ease of description, the following uses an example in which the memory capacitor C is of an MFM structure for description.

In addition, materials of the first metal oxide layer 33 and the second metal oxide layer 34 may include niobium oxide (for example, NbO) in Table 3, and thicknesses of the first metal oxide layer 33 and the second metal oxide layer 34 may be from 0.5 nm to 2 nm. The thickness of either the first metal oxide layer 33 or the second metal oxide layer 34 being within a range of 0.5 nm to 2 nm can avoid the metal oxide layer from being too thin, thereby avoiding insufficient stretching action on the ferroelectric layer 30 and an unobvious lattice distortion in the ferroelectric layer 30. In addition, this can avoid the metal oxide layer from being too thick, thereby avoiding large voltage division on the ferroelectric layer 30, and avoiding adverse effect on reducing of the operating voltage and ultra-thin design of the product.

**Table 3**

| Film layer | Material | Thickness |
|---|---|---|
| First electrode | W/TiN | 5 nm to 100 nm |
| First metal oxide layer | NbO | 0.5 nm to 2 nm |
| Ferroelectric layer | HZTO | 3 nm to 20 nm |
| Second metal oxide layer | NbO | 0.5 nm to 2 nm |
| Second electrode | W/TiN | 5 nm to 100 nm |

In this way, for the structure shown in FIG. 13, the first metal oxide layer 33 and the second metal oxide layer 34 are respectively disposed on two opposite sides of the ferroelectric layer 30, so that the crystal structure of the ferroelectric layer 30 is more likely to undergo the lattice distortion under the stretching action of the first metal oxide layer 33 and the second metal oxide layer 34, thereby increasing the ferroelectricity of the ferroelectric layer 30, making it easier to implement the polarity reversal of the ferroelectric layer 30, and reducing the operating voltage of the memory 20. In view of this, in the related technology shown in FIG. 7, because no metal oxide layer used to stretch the ferroelectric layer 30, for example, the first metal oxide layer 33 and the second metal oxide layer 34 (as shown in FIG. 13), is disposed in the memory capacitor C, a proportion of the O phase in the memory capacitor C is small, and ferroelectricity of the ferroelectric layer is weak, leading to an increase in the difficulty of the polarity reversal of the ferroelectric layer, and causing a larger coercive field E_{C} of the memory. It can be learned from the PV curve shown in FIG. 14 that the coercive field E_{C} may be 1.6 MV/cm. Therefore, an operating electric field and an operating voltage of the memory in the related technology are large. As shown in Table 4, the operating electric field and the operating voltage may be respectively 3 MV/cm and 2.4 V, which is not conducive to reducing power consumption.

In comparison, it can be learned from the foregoing that the memory capacitor C in the memory provided in this embodiment of this application is shown in FIG. 13. Disposing the metal oxide layer, for example, the first metal oxide layer 33 and the second metal oxide layer 34, can increase the proportion of the O phase in the memory capacitor C, to reduce the coercive field E_{C}. For example, it can be learned from the PV curve shown in FIG. 15 that the coercive field E_{C} may be 0.9 MV/cm. Therefore, compared with the related technology shown in FIG. 7, the memory provided in this embodiment of this application can greatly reduce the coercive field E_{C} from 1.6 MV/cm to 0.9 MV/cm shown in Table 4, so that the memory has a smaller operating electric field and operating voltage. As shown in Table 4, the operating electric field and the operating voltage may be 2 MV/cm and 1.5 V respectively, thereby helping reduce power consumption.

**Table 4**

| Parameter | Memory not disposed with the first metal oxide layer and the second metal oxide layer | Memory disposed with the first metal oxide layer and the second metal oxide layer |
|---|---|---|
| Coercive field E_{C} | 1.6 MV/cm | 0.9 MV/cm |
| Breakdown electric field E_{BD} | 3.6 MV/cm | 5.5 MV/cm |
| E_{C}/E_{BD} | 44% | 16% |
| Operating electric field | 3 MV/cm | 2 MV/cm |
| Operating voltage | 2.4 V | 1.5 V |
| Memory window 2Pr | 25 to 30 µC/cm² | 40 to 50 µC/cm² |
| Endurance | 1e-08 cycles and no breakdown occurs | 1e+11 cycles and no breakdown occurs |

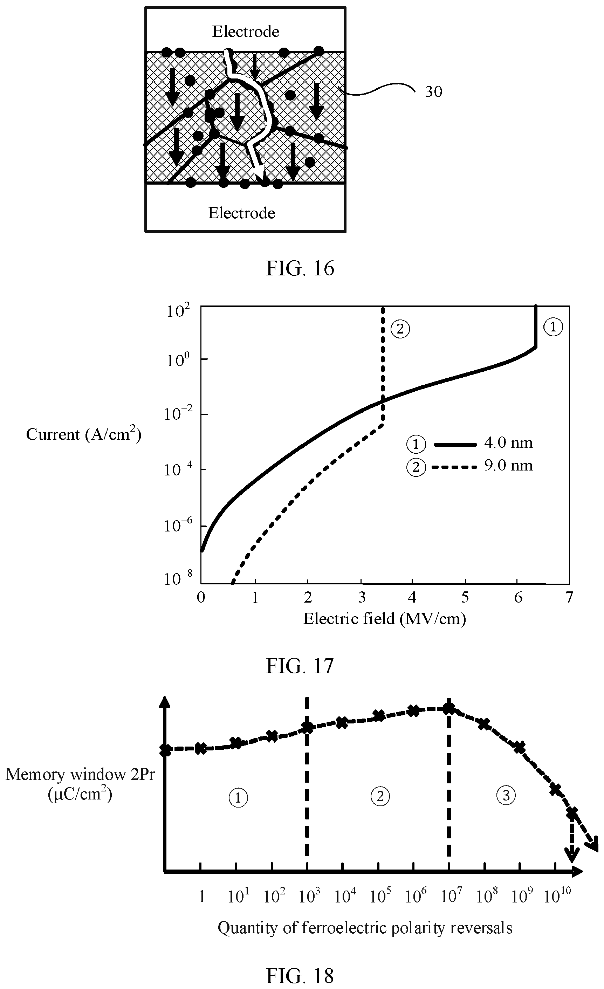

In addition, as shown in FIG. 16, accumulated defects (as shown by cracks in the figure) in the material of the ferroelectric layer 30 may cause a breakdown phenomenon of the ferroelectric layer 30 in a process of using the memory capacitor C, thereby causing a device failure. In view of this, it can be learned from FIG. 17 (a curve diagram of a relationship between electric field strengths and currents of ferroelectric layers with different thicknesses) that, a greater electric field strength indicates a larger current, and easier breakdown of the ferroelectric layer. In addition, a thinner thickness of the ferroelectric layer indicates a greater anti-breakdown capability. The curve ① indicates that the thickness of the ferroelectric layer is about 4.0 nm, and the curve ② indicates that the thickness of the ferroelectric layer is about 9.0 nm. For example, it can be learned from the curve ① that the ferroelectric layer with a thickness of about 4.0 nm is broken down when the electric field strength is about 6 MV/cm. It can be learned from the curve ② that the ferroelectric layer with a thickness of about 9.0 nm is broken down when the electric field strength is about 3.2 MV/cm.

In view of this, a smaller thickness of the ferroelectric layer 30 indicates a larger breakdown electric field E_{BD} and better anti-breakdown performance. When the thickness of the ferroelectric layer 30 is usually within a range of 7 nm to 10 nm, a corresponding breakdown electric field E_{BD} is 3.5 MV/cm to 4 MV/cm. In addition, a smaller thickness of the ferroelectric layer 30 indicates a smaller E_{C}/E_{BD}. When the thickness of the ferroelectric layer 30 is usually within a range of 7 nm to 10 nm, E_{C}/E_{BD} is 35% to 40%. E_{C}/E_{BD} may represent an anti-breakdown capability of the ferroelectric layer 30. A larger E_{C}/E_{BD} value indicates that E_{C} is closer to E_{BD}, and the anti-breakdown capability is weaker. On the contrary, a smaller E_{C}/E_{BD} value indicates a larger difference between E_{C} and E_{BD} and a stronger anti-breakdown capability.

For example, in the related technology shown in FIG. 7, when the thickness of the ferroelectric layer is 8 nm, it can be learned from the foregoing that the breakdown electric field E_{BD} may be 3.6 MV/cm shown in Table 4, and the coercive field E_{C} may be 1.6 MV/cm. In this case, E_{C}/E_{BD} is 44%. The ratio of the coercive field E_{C} to the breakdown electric field E_{BD} is large, and the ferroelectric layer has a high breakdown risk.

In view of this, in the related technology, to improve the anti-breakdown capability, when the thickness of the ferroelectric layer is reduced, for example, the thickness of the ferroelectric layer is reduced to 7 nm or less, to enable the ferroelectric layer to have corresponding ferroelectricity, a high crystallization requirement is imposed on the ferroelectric layer, and therefore, a crystallization temperature needs to be increased to meet the crystallization requirement. However, in a process of manufacturing the memory, the transistor T shown in FIG. 6A is usually prepared by using a front-end-of-line (front-end-of-line, FEOL) process, and then the memory capacitor C is prepared by using a back-end-of-line (back-end-of-line, BEOL) process. Therefore, when the crystallization temperature of the ferroelectric layer in the memory capacitor C is increased to meet the higher crystallization requirement, the transistor prepared by using FEOL is affected. Therefore, to reduce impact on the transistor, the crystallization temperature of the ferroelectric layer needs to be limited. As a result, the thickness of the ferroelectric layer cannot be further reduced in the related technology.

In comparison, it can be learned from the foregoing that, in the memory capacitor C shown in FIG. 13 provided in this embodiment of this application, the first metal oxide layer 33 and the second metal oxide layer 34 are respectively disposed on two opposite sides of the ferroelectric layer 30, so that the crystal structure of the ferroelectric layer 30 is more likely to undergo the lattice distortion under the stretching action of the first metal oxide layer 33 and the second metal oxide layer 34, thereby increasing the proportion of the O phase in the lattice structure of the ferroelectric layer 30, reducing oxygen vacancies, improving the crystallization level of ferroelectric layer 30, and increasing the ferroelectricity of the ferroelectric layer 30.

In this way, on the one hand, the ferroelectric layer 30 with a higher crystallization level has fewer defects, thereby helping improve the breakdown electric field E_{BD}. For example, as shown in Table 4, the breakdown electric field E_{BD} of the ferroelectric layer 30 provided in this embodiment of this application may be 5.5 MV/cm, and the coercive field E_{C} is 0.9 MV/cm. Therefore, E_{C}/E_{BD} is 16%. Compared with the memory capacitor C provided in the related technology shown in FIG. 7, the memory capacitor C provided in this embodiment of this application can effectively improve the breakdown electric field E_{BD}, and reduce the coercive field E_{C} and E_{C}/E_{BD}, thereby effectively reducing power consumption and improving the anti-breakdown capability of the ferroelectric layer 30.

On the other hand, because the ferroelectric layer 30 in the memory capacitor C provided in this embodiment of this application has a higher crystallization level, compared with the related technology shown in FIG. 7, when a crystallization requirement is the same, a corresponding crystallization requirement can be met without increasing the crystallization temperature of the ferroelectric layer in the memory capacitor C provided in this embodiment of this application. Therefore, when the crystallization requirement is the same, the thickness of the ferroelectric layer 30 provided in this embodiment of this application can be reduced. For example, as shown in Table 5, a thickness range of the ferroelectric layer 30 may be from 5 nm to 8 nm. In this way, reducing the thickness of the ferroelectric layer 30 can be conducive to a design trend of product size miniaturization. In addition, a smaller thickness of the ferroelectric layer 30 indicates a larger breakdown electric field E_{BD} and better anti-breakdown performance.

**Table 5**

| Thickness of the ferroelectric layer (nm) | 8 | 7 | 6 | 5 |
|---|---|---|---|---|
| Coercive field E_{C} (MV/cm) | 0.89 | 0.85 | 0.98 | 0.94 |
| Coercive voltage V_{C} (V) | 0.71 | 0.60 | 0.59 | 0.47 |
| Operating voltage (V) | 1.8 | 1.6 | 1.5 | 1.2 |
| Memory window 2Pr (µC/cm²) | 50 | 45 | 38 | 31 |

It can be learned from Table 5 that, as the thickness of the ferroelectric layer 30 is reduced from 8 nm to 5 nm, the coercive field E_{C} basically remains unchanged, the coercive voltage V_{C} gradually decreases, and the operating voltage may also gradually decrease as the thickness decreases. In this way, the operating voltage can be effectively reduced by preparing the ferroelectric layer 30 with a smaller thickness, thereby reducing power consumption, and implementing a design of product size miniaturization while improving anti-breakdown performance.

According to still another aspect, for a memory having the memory capacitor C provided in the related technology shown in FIG. 7, as shown in FIG. 14, the memory window 2Pr may be 30 µC/cm² (2×15 µC/cm²). Therefore, as shown in Table 4, when no metal oxide layer used to stretch the ferroelectric layer is disposed in the memory capacitor C, the memory window 2Pr may be within a range of 25-30 µC/cm². In comparison, because the ferroelectric layer 30 in the memory capacitor C shown in FIG. 13 provided in this embodiment of this application has a higher crystallization level, the memory window 2Pr of the memory can be increased. As shown in FIG. 15, the memory window 2Pr may be 50 µC/cm² (2×25 µC/cm²).

Therefore, as shown in Table 4, when the metal oxide layer (for example, the first metal oxide layer 33 and the second metal oxide layer 34) used to stretch the ferroelectric layer is disposed in the memory capacitor C, the memory window 2Pr may be within a range of 40-50 µC/cm². For example, as shown in Table 5, when the thicknesses of the ferroelectric layer 30 are respectively 8 nm, 7 nm, 6 nm, and 5 nm, the memory window 2Pr of the memory may be respectively 50 µC/cm², 45 µC/cm², 38 µC/cm², and 31 µC/cm².

On this basis, endurance (Endurance) may determine a service life of the memory 20. As shown in FIG. 18, a ferroelectric polarity reversal period may include: ① a pristine (pristine) phase, ② a wake-up (wake up) effect, and ③ a fatigue (fatigue) phase. It can be learned from FIG. 18 that, in a process of phase transition from the O phase to a non-ferroelectric phase (for example, an M phase) in the ferroelectric layer 30 in the memory 20, ferroelectric fatigue may cause a reduction in the ferroelectric polarization strength, a loss of the memory window 2Pr, and a risk of a device breakdown failure (after the phase 3).

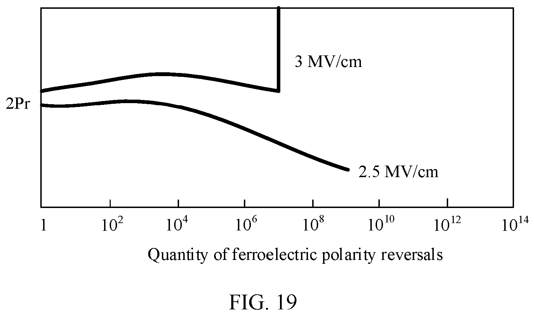

For example, in the related technology shown in FIG. 7, when no metal oxide used to stretch the ferroelectric layer is disposed in the memory capacitor C, as shown in FIG. 19 (a diagram of a relationship between a quantity of ferroelectric polarity reversals and the memory window), a smaller operating electric field (for example, an operating electric field of about 2.5 MV/cm is smaller than an operating electric field of about 3 MV/cm) indicates a larger quantity of ferroelectric polarity reversals (for example, when the operating electric field is 2.5 MV/cm, the quantity of ferroelectric polarity reversals may reach 1e+08 cycles and no breakdown occurs). However, a smaller operating electric field (for example, the operating electric field is 2.5 MV/cm) indicates an easier reduction in the memory window 2Pr (for example, when the quantity of ferroelectric polarity reversals is 1e8, the memory window 2Pr is about 10 µC/cm²), and there is a severe loss of the memory window 2Pr.

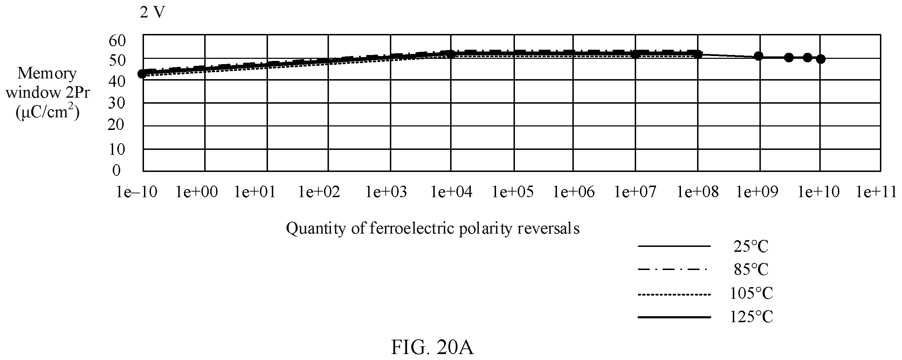

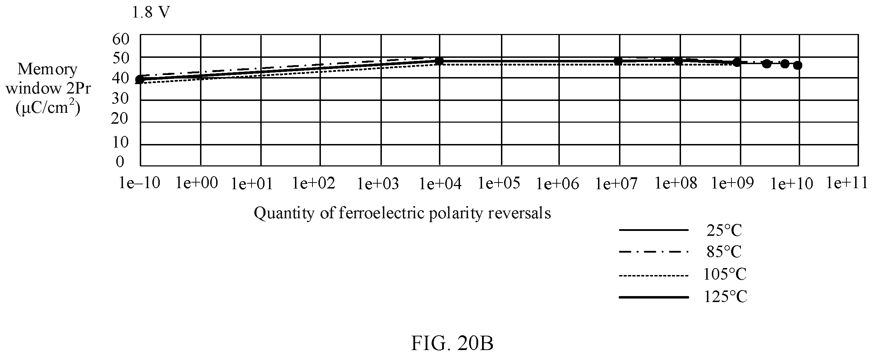

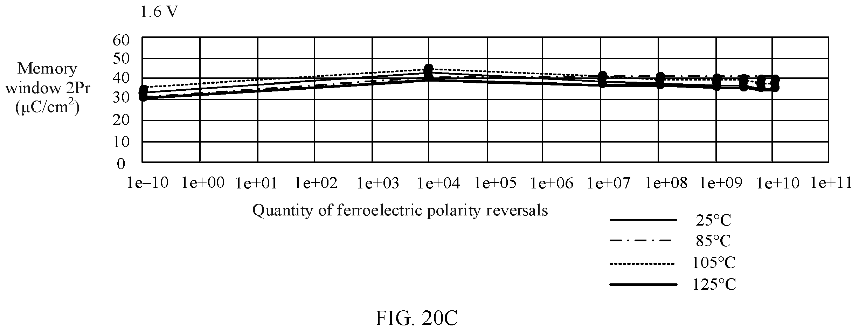

In view of this, compared with the related technology shown in FIG. 7, for example, in the memory provided in this embodiment of this application, when the operating voltages are 2 V, as shown in FIG. 20A, the quantity of ferroelectric polarity reversals reaches 1e+10 cycles in an operating environment of 25°C and no breakdown occurs. Alternatively, for another example, when the operating voltages are 1.8 V, as shown in FIG. 20B, the quantity of ferroelectric polarity reversals reaches 1e+10 cycles in an operating environment of 25°C and no breakdown occurs. Alternatively, for another example, when the operating voltages are 1.6 V, as shown in FIG. 20C, the quantity of ferroelectric polarity reversals reaches 1e+10 cycles in operating environments of 25°C, 85°C, 105°C, and 125°C respectively and no breakdown occurs. In some other embodiments of this application, the quantity of ferroelectric polarity reversals of the memory provided in this embodiment of this application may reach 1e+11 or 1e+14 cycles and no breakdown occurs in Table 4, thereby improving endurance of the memory.

In addition, as shown in FIG. 20A, when the operating voltage of the memory is 2 V, operating states of the memory in the high-temperature environment are tested at 25°C, 85°C, 105°C, and 125°C in sequence. It can be learned that as the quantity of ferroelectric polarity reversals increases, the memory window 2Pr can be retained within a range of 40-50 µC/cm² in FIG. 5A, and there is no loss of the memory window 2Pr. Similarly, as shown in FIG. 20B, when the operating voltage of the memory is 1.8 V, operating states of the memory in the high-temperature environment are tested at 25°C, 85°C, 105°C, and 125°C in sequence. It can be learned that as the quantity of ferroelectric polarity reversals increases, the memory window 2Pr can be retained within a range of 40-50 µC/cm² in FIG. 5A, and there is no loss of the memory window 2Pr. Similarly, as shown in FIG. 20C, when the operating voltage of the memory is 1.6 V, operating states of the memory in the high-temperature environment are tested at 25°C, 85°C, 105°C, and 125°C in sequence. It can be learned that as the quantity of ferroelectric polarity reversals increases, the memory window 2Pr can be retained within a range of 40-50 µC/cm² in FIG. 5A, and there is no loss of the memory window 2Pr.

In this way, according to the memory provided in this embodiment of this application, endurance of the memory can be improved while the operating voltage (for example, the operating voltage is 2 V, 18 V, or 2 V) of the memory is reduced to reduce power consumption, and losses of the memory window 2Pr are reduced. Therefore, the memory has better high-temperature reliability, and can be applied to an industrial-grade (the operating temperature may reach 85°C) or an automotive-grade (the operating temperature may reach 125°C).

In addition, a unique imprint (imprint) effect of the ferroelectric material may cause an offset of the ferroelectric polarization curve at the high temperature, resulting in the decrease of the memory window 2Pr and the difficulty in data storage. Therefore, retention (Retention) of memory is a core reliability index of the memory in the high-temperature operating environment. For example, a high-temperature accelerated aging experiment at 175°C for 6 h may be separately performed on the memory in the related technology shown in FIG. 7 and the memory provided in the embodiment of this application shown in FIG. 13. A data result of stored information "0" obtained from the high-temperature accelerated aging experiment at 175°C for 6 h may be shown in Table 6, and a data result of stored information "1" obtained from the high-temperature accelerated aging experiment at 175°C for 6 h may be shown in Table 7.

**Table 6**

| Stored information "0" in the high-temperature accelerated aging experiment at 175°C for 6 h | Memory not disposed with the first metal oxide layer and the second metal oxide layer | Memory disposed with the first metal oxide layer and the second metal oxide layer |
|---|---|---|
| 2Pr remaining after high temperature | 12 µC/cm² | 46 µC/cm² |
| 2Pr loss after high temperature | Loss: 66% | Loss: 7% |
| PV curve offset ΔE_{C} caused by high temperature | -0.87 MV/cm | -0.21 MV/cm |

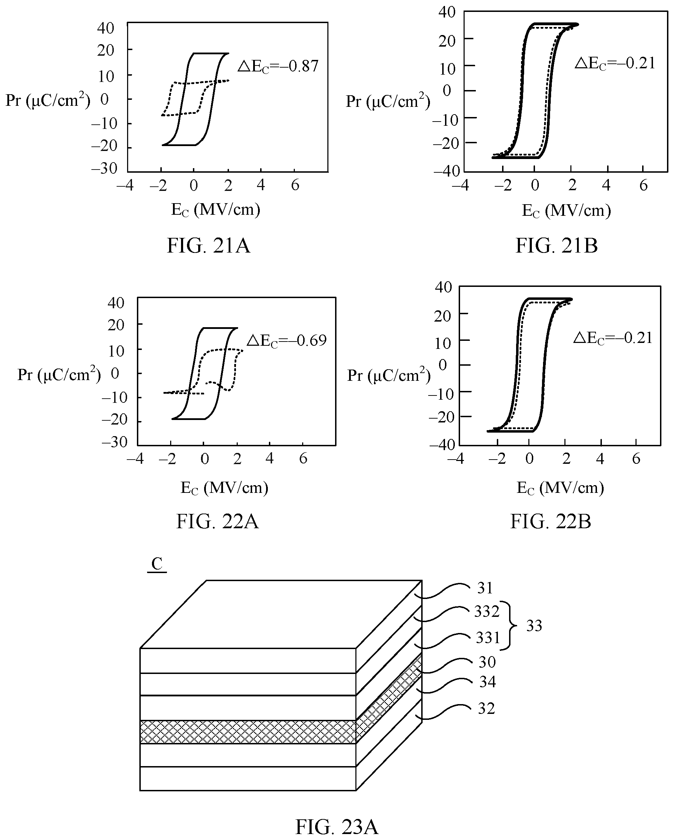

As shown in FIG. 21A, after the high-temperature accelerated aging experiment at 175°C for 6 h is performed on a memory in which the first metal oxide layer and the second metal oxide layer are not disposed to store information "0", a PV curve offset is large, and the memory window 2Pr is greatly reduced. Specifically, as shown in Table 6, the PV curve offset △E_{C} is -0.87 MV/cm. After the high temperature, the remaining memory window 2Pr is 12 µC/cm². Compared with the memory window 2Pr (36 µC/cm²) before the high-temperature accelerated aging experiment, the memory window is lost by 66%.

In comparison, as shown in FIG. 21B, after the high-temperature accelerated aging experiment at 175°C for 6 h is performed on a memory in which the first metal oxide layer 33 and the second metal oxide layer 34 shown in FIG. 13 are disposed to store information "0", a PV curve offset is smaller, and a loss of the memory window 2Pr is smaller. Specifically, as shown in Table 6, the PV curve offset △E_{C} is -0.21 MV/cm, and the PV curve offset △E_{C} is smaller. Therefore, the remaining memory window 2Pr of the memory after the high temperature is large, and is approximately 46 µC/cm². Compared with the memory window 2Pr (50 µC/cm²) before the high-temperature accelerated aging experiment, the memory window is lost by 7%.

**Table 7**

| Stored information 1 in the high-temperature accelerated aging experiment at 175°C for 6 h | Memory not disposed with the first metal oxide layer and the second metal oxide layer | Memory disposed with the first metal oxide layer and the second metal oxide layer |
|---|---|---|
| 2Pr remaining after high temperature | 16 µC/cm² | 47 µC/cm² |
| 2Pr loss after high temperature | Loss: 58% | Loss: 7% |
| PV curve offset ΔE_{C} caused by high temperature | -0.69 MV/cm | -0.21 MV/cm |

Similarly, as shown in FIG. 22A, after the high-temperature accelerated aging experiment at 175°C for 6 h is performed on a memory in which the first metal oxide layer and the second metal oxide layer are not disposed to store information "1", a PV curve offset is large, and the memory window 2Pr is greatly reduced. Specifically, as shown in Table 7, the PV curve offset △E_{C} is -0.69 MV/cm. After the high temperature, the remaining memory window 2Pr is 16 µC/cm². Compared with the memory window 2Pr (36 µC/cm²) before the high-temperature accelerated aging experiment, the memory window is lost by 58%.

In comparison, as shown in FIG. 22B, after the high-temperature accelerated aging experiment at 175°C for 6 h is performed on a memory in which the first metal oxide layer 33 and the second metal oxide layer 34 shown in FIG. 13 are disposed to store information "1", a PV curve offset is smaller, and a loss of the memory window 2Pr is smaller. Specifically, as shown in Table 7, the PV curve offset △E_{C} is -0.21 MV/cm, and the PV curve offset △E_{C} is smaller. Therefore, the remaining memory window 2Pr of the memory after the high temperature is large, and is approximately 47 µC/cm². Compared with the memory window 2Pr (50 µC/cm²) before the high-temperature accelerated aging experiment, the memory window is lost by 7%.

In conclusion, the memory provided in this embodiment of this application has the first metal oxide layer 33 and the second metal oxide layer 34 shown in FIG. 13. The ferroelectricity and the crystallization level of the ferroelectric layer 30 can be improved under the stretching action of the first metal oxide layer 33 and the second metal oxide layer 34 on the ferroelectric layer 30. In this way, the coercive field E_{C} (for example, E_{C}=0.9 MV/cm) and the operating voltage (for example, 1.5 V) can be effectively reduced to reduce power consumption, and the breakdown electric field E_{BD} (for example, E_{BD}=5.5 MV/cm) can be increased to improve the anti-breakdown capability. In addition, endurance of the memory can be improved. For example, endurance can reach 1e+11 cycles and no breakdown occurs, the memory window 2Pr is increased (for example, 2Pr=40 to 50 µC/cm²), and losses of the memory window 2Pr are reduced. In this way, the memory has good retention (that is, high-temperature reliability), and can be applied to the industrial-grade (the operating temperature may reach 85°C) or automotive-grade (the operating temperature may reach 125°C). In addition, in the high-temperature accelerated aging experiment, the memory window 2Pr is less lost (for example, 7% is lost).

The foregoing is described by using an example in which there is a metal oxide layer used to stretch the ferroelectric layer 30 between the electrode and the ferroelectric layer 30 in the memory capacitor C shown in FIG. 13. For example, there is a first metal oxide layer 33 between the first electrode 31 and the ferroelectric layer 30, and there is a second metal oxide layer 34 between the second electrode 32 and the ferroelectric layer 30. In some other embodiments of this application, there may be two or more metal oxide layers between the electrode and the ferroelectric layer 30. For example, the plurality of first metal oxide layers 33 in the memory capacitor C may include a first bottom metal oxide layer 331 and a first top metal oxide layer 332 shown in FIG. 23A. The first top metal oxide layer 332 is stacked on a side that is of the first bottom metal oxide layer 331 and that is away from the first electrode 31. A material of the first top metal oxide layer 332 may be different from a material of the first bottom metal oxide layer 331. Technical effect and manufacturing methods of the first bottom metal oxide layer 331 and the first top metal oxide layer 332 are the same as those of the first metal oxide layer 33. Details are not described herein again.

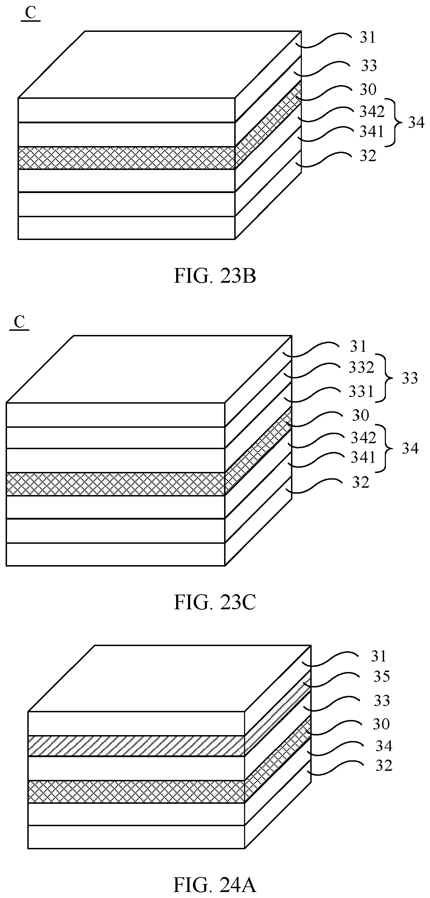

Alternatively, for another example, the plurality of second metal oxide layers 34 in the memory capacitor C may include a second bottom metal oxide layer 341 and a second top metal oxide layer 342 shown in FIG. 23B. The second top metal oxide layer 342 is stacked on a side that is of the second bottom metal oxide layer 341 and that is away from the second electrode 33. A material of the second bottom metal oxide layer 341 may be different from a material of the second top metal oxide layer 342. Technical effect and manufacturing methods of the second bottom metal oxide layer 341 and the second top metal oxide layer 342 are the same as those of the second metal oxide layer 34. Details are not described herein again.

Alternatively, for another example, the plurality of first metal oxide layers 33 in the memory capacitor C may include a first bottom metal oxide layer 331 and a first top metal oxide layer 332 shown in FIG. 23C, and the plurality of second metal oxide layers 34 may include a second bottom metal oxide layer 341 and a second top metal oxide layer 342. Disposing manners, manufacturing methods, and technical effect of the first bottom metal oxide layer 331, the first top metal oxide layer 332, the second bottom metal oxide layer 341, and the second top metal oxide layer 342 are the same as those described above. Details are not described herein again.

The foregoing is described by using an example in which there may be two metal oxide layers between the electrode and the ferroelectric layer 30 in the memory capacitor C. In some other embodiments of this application, there may be more than two metal oxide layers between the electrode and the ferroelectric layer 30. Details are not described herein again in this application.

In some other embodiments of this application, the memory capacitor C may further include a first transition layer 35 shown in FIG. 24A. The first transition layer 35 is stacked between the first electrode 31 and the first metal oxide layer 33. The first transition layer 35 may include a third metal oxide, and a metal element in the third metal oxide of the first transition layer 35 may be the same as at least one metal element of the first electrode 31.

In this way, because the third metal oxide in the first transition layer 35 has an oxygen element, an interface between the first metal oxide layer 33 and the first transition layer 35 can be optimized, to reduce defects of the interface. In addition, because the metal element in the third metal oxide of the first transition layer 35 may be the same as the at least one metal element of the first electrode 31, the first transition layer 35 can optimize an interface between the first electrode 31 and the first transition layer 35, to reduce defects of the interface, so that transition can be performed between the first electrode 31 and the first metal oxide layer 33, thereby improving performance and reliability of the device.

For example, when the first electrode 31 includes tungsten (W), the third metal oxide of the first transition layer 35 may include tungsten oxide (for example, WO₃). Alternatively, when the first electrode 31 includes titanium (Ti), the third metal oxide of the first transition layer 35 may include titanium oxide (for example, TiO₂). Alternatively, when the first electrode 31 includes ruthenium (Ru), the third metal oxide of the first transition layer 35 may include ruthenium oxide (for example, RuO₂).

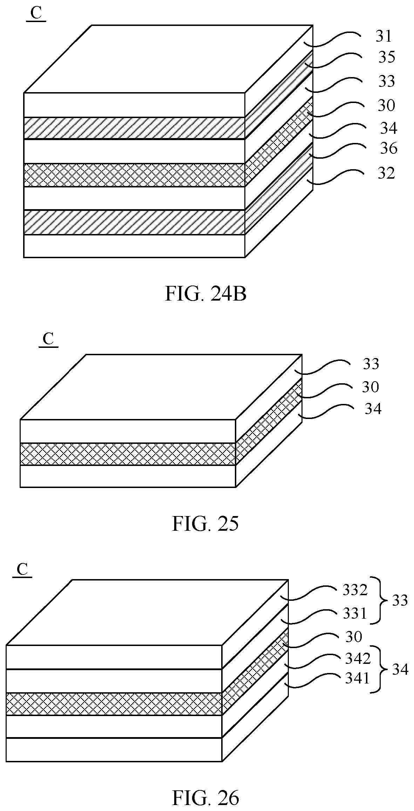

Similarly, as shown in FIG. 24B, the memory capacitor C may further include a second transition layer 36 shown in FIG. 24B. The second transition layer 36 is stacked between the second electrode 32 and the second metal oxide layer 34. Similarly, the second transition layer 36 may include a fourth metal oxide, and a metal element in the fourth metal oxide of the second transition layer 36 may be the same as at least one metal element of the second electrode 32. A material and technical effect of the second transition layer 36 are the same as those of the first transition layer 35. Details are not described herein again.

In some other embodiments of this application, the memory capacitor C may include a first metal oxide layer 33, a ferroelectric layer 30, and a second metal oxide layer 34 shown in FIG. 25. The ferroelectric layer 30 is stacked between the first metal oxide layer 33 and the second metal oxide layer 34. As described above, the metal element in the first metal oxide of the first metal oxide layer 33 and the metal element in the second metal oxide of the second metal oxide layer 34 may include at least one metal element in a group III (III), group IV (IV), or group V (V) element other than a hafnium (Hf) element. The first metal oxide layer 33 and the second metal oxide layer 34 may stretch the ferroelectric layer 30, so that the ferroelectric layer 30 has the lattice distortion. Technical effect of the first metal oxide layer 33 and the second metal oxide layer 34 is the same as that described above. Details are not described herein again.

On this basis, a dielectric constant of the first metal oxide layer 33 and a dielectric constant of the second metal oxide layer 34 may be greater than a dielectric constant of the ferroelectric layer 30. For example, the first metal oxide of the first metal oxide layer 33 and the second metal oxide of the second metal oxide layer 34 may include at least one of lanthanum oxide (for example, La₂O₃), cerium oxide (for example, CeO₂), niobium oxide (for example, NbO, NbO₂, Nb₂O₃ or Nb₂O₅), tantalum oxide (Ta₂O₅), or vanadium oxide (for example, VO or V₂O₃). In this case, the first metal oxide layer 33 and the second metal oxide layer 34 may be conductive, so that the electrodes (for example, the first electrode 31 and the second electrode 32 shown in FIG. 13) do not need to be disposed in the memory capacitor C. In this way, the thickness of the device can be reduced, which is conducive to a design trend of product miniaturization. In addition, the memory capacitor may further include a plurality of first metal oxide layers, for example, a first bottom metal oxide layer 331 and a first top metal oxide layer 332, as shown in FIG. 26, and a plurality of second metal oxide layers, for example, a second bottom metal oxide layer 341 and a second top metal oxide layer 342. Disposing manners, manufacturing methods, and technical effect of the first bottom metal oxide layer 331, the first top metal oxide layer 332, the second bottom metal oxide layer 341, and the second top metal oxide layer 342 are the same as those described above. Details are not described herein again.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A memory cell, comprising a transistor and a memory capacitor electrically connected to the transistor, wherein the memory capacitor comprises:
a first electrode;
a ferroelectric layer, stacked with the first electrode, wherein the ferroelectric layer is a doped hafnium oxide-based ferroelectric layer;
a first metal oxide layer, stacked between the first electrode and the ferroelectric layer, wherein the first metal oxide layer comprises a first metal oxide, and a metal element in the first metal oxide comprises at least one metal element from group III, group IV, or group V element, excluding hafnium; and
a second electrode, stacked on a side that is of the ferroelectric layer and that is away from the first electrode.

2. The memory cell according to claim 1, wherein
a dielectric constant of the first metal oxide layer is greater than a dielectric constant of the ferroelectric layer, and the dielectric constant of the first metal oxide layer is less than a dielectric constant of the first electrode.

3. The memory cell according to claim 1 or 2, wherein the memory capacitor further comprises:
a second metal oxide layer, stacked between the second electrode and the ferroelectric layer, wherein the second metal oxide layer comprises a second metal oxide, and a metal element in the second metal oxide comprises at least one metal element from group III, group IV, or group V element, excluding hafnium.

4. The memory cell according to claim 3, wherein
a dielectric constant of the second metal oxide layer is greater than the dielectric constant of the ferroelectric layer, and the dielectric constant of the second metal oxide layer is less than a dielectric constant of the second electrode.

5. The memory cell according to any one of claims 1 to 4, wherein the memory capacitor comprises a plurality of first metal oxide layers:
a first bottom metal oxide layer; and
a first top metal oxide layer, stacked on a side that is of the first bottom metal oxide layer and that is away from the first electrode, wherein a material of the first top metal oxide layer is different from a material of the first bottom metal oxide layer.

6. The memory cell according to any one of claims 1 to 5, wherein the memory capacitor further comprises:
a first transition layer, stacked between the first electrode and the first metal oxide layer, wherein the first transition layer comprises a third metal oxide, and a metal element in the third metal oxide is the same as at least one metal element of the first electrode.

7. The memory cell according to any one of claims 3 to 6, wherein the memory capacitor further comprises:
a second transition layer, stacked between the second electrode and the second metal oxide layer, wherein the second transition layer comprises a fourth metal oxide, and a metal element in the fourth metal oxide is the same as at least one metal element of the second electrode.

8. The memory cell according to claim 6 or 7, wherein
the first electrode comprises tungsten, and the third metal oxide comprises tungsten oxide; or
the first electrode comprises titanium, and the third metal oxide comprises titanium oxide; or
the first electrode comprises ruthenium, and the third metal oxide comprises ruthenium oxide.

9. The memory cell according to claim 1, wherein the first metal oxide comprises at least one of yttrium oxide, scandium oxide, lanthanum oxide, cerium oxide, titanium oxide, niobium oxide, tantalum oxide, or vanadium oxide.

10. The memory cell according to claim 2, wherein the first metal oxide comprises at least one of lanthanum oxide, cerium oxide, titanium oxide, niobium oxide, tantalum oxide, or vanadium oxide.

11. The memory cell according to any one of claims 1 to 10, wherein a thickness of the first metal oxide layer is from 0.5 nm to 2 nm.

12. The memory cell according to any one of claims 1 to 11, wherein a thickness of the ferroelectric layer is from 3 nm to 20 nm.

13. The memory cell according to any one of claims 1 to 12, wherein the ferroelectric layer comprises hafnium oxide and a doping material, and the doping material comprises at least one of zirconium, titanium, niobium, lanthanum, cerium, gadolinium, yttrium, aluminum, or strontium.

14. A memory cell, comprising a transistor and a memory capacitor electrically connected to the transistor, wherein the memory capacitor comprises:
a first metal oxide layer;
a ferroelectric layer, stacked on the first metal oxide layer, wherein the ferroelectric layer is a doped hafnium oxide-based ferroelectric layer, the first metal oxide layer comprises a first metal oxide, a metal element in the first metal oxide comprises at least one metal element from group III, group IV, or group V element, excluding hafnium, and a dielectric constant of the first metal oxide layer is greater than a dielectric constant of the ferroelectric layer; and
a second metal oxide layer, stacked on a side that is of the ferroelectric layer and that is away from the first metal oxide layer, wherein a dielectric constant of the second metal oxide layer is greater than the dielectric constant of the ferroelectric layer, the second metal oxide layer comprises a second metal oxide, and a metal element in the second metal oxide comprises at least one metal element from group III, group IV, or group V element, excluding hafnium.

15. The memory cell according to claim 14, wherein the memory capacitor comprises a plurality of first metal oxide layers:
a first bottom metal oxide layer; and
a first top metal oxide layer, stacked on a side that is of the first bottom metal oxide layer and that faces the ferroelectric layer, wherein a material of the first top metal oxide layer is different from a material of the first bottom metal oxide layer.

16. The memory cell according to claim 14 or 15, wherein the first metal oxide comprises at least one of lanthanum oxide, cerium oxide, titanium oxide, niobium oxide, tantalum oxide, or vanadium oxide.

17. A memory array, comprising:
a first electrode line;
a second electrode line;
a third electrode line; and
the memory cell according to any one of claims 1 to 13, or the memory cell according to any one of claims 14 to 16, wherein
a control end of the transistor is electrically connected to the first electrode line, a first electrode of the transistor is electrically connected to the second electrode line, and a second electrode of the transistor is electrically connected to the third electrode line through the memory capacitor.

18. A memory array, comprising:
a second electrode line, a third electrode line, and a memory capacitor, wherein the memory capacitor comprises:
a first electrode, electrically connected to the second electrode line;
a ferroelectric layer, stacked with the first electrode, wherein the ferroelectric layer is a doped hafnium oxide-based ferroelectric layer;
a first metal oxide layer, stacked between the first electrode and the ferroelectric layer, wherein the first metal oxide layer comprises a first metal oxide, and a metal element in the first metal oxide comprises at least one metal element from group III, group IV, or group V element, excluding hafnium; and
a second electrode, stacked on a side that is of the ferroelectric layer and that is away from the first electrode, wherein the second electrode is electrically connected to the third electrode line.

19. The memory array according to claim 18, wherein
a dielectric constant of the first metal oxide layer is greater than a dielectric constant of the ferroelectric layer, and the dielectric constant of the first metal oxide layer is less than a dielectric constant of the first electrode.

20. A memory, comprising:
the memory array according to claim 17, 18, or 19; and
a controller, wherein the controller is electrically connected to the memory array, and the controller is configured to control read/write of the memory array.

21. An electronic device, comprising:
a circuit board; and
the memory according to claim 20, wherein the circuit board is electrically connected to the memory.
